# EUROPEAN PATENT APPLICATION

(11) **EP 4 851 996 A1**
(43) Date of publication of application: **09.12.2026**
(21) Application number: 26181807.4
(22) Date of filing: 29.05.2026
(51) Int. Cl.: G11C 5/02, H10W 90/00

(54) **MEMORY MODULE AND COMPUTING SYSTEM USING THE SAME**

(30) Priority: 04.06.2025 KR 20250072885; 11.07.2025 US 202519267161
(71) Applicant: SK hynix Inc., Bubal-eub Icheon-si, Gyeonggi-do 17336 (KR)
(72) Inventor: LEE, Seong Ju, 95134 San Jose, California (US)
(74) Representative: Isarpatent

(57) **Abstract**

A memory module may include a module substrate, a first memory package, a second memory package, and a module controller circuit. The module substrate may include first signal transmission lines and second signal transmission lines. Memory chips of the first memory package may be coupled in common to the first signal transmission lines. Memory chips of the second memory package may be coupled in common to the second signal transmission lines. The module controller circuit may connect a data bus to one of the first signal transmission lines and the second signal transmission lines based on a chip selection signal.

## Description

### BACKGROUND

### 1.TECHNICAL FIELD

Various embodiments generally relate to integrated circuit technology, and, more particularly, to a memory module and a computing system using the same.

### 2. RELATED ART

With the recent advent of big data, artificial intelligence, and high-performance applications, the amount of data that needs to be processed in computing systems has been increasing, and the computation performance has become more advanced. Generally, a computing system may include a host apparatus and a memory apparatus. The host apparatus may access the memory apparatus to read data required for computation from the memory apparatus, perform computation on the read data, and write the computed data back to the memory apparatus. As the computation performance of the host apparatus increases, there is a need to transmit a larger amount of data between the host apparatus and the memory apparatus, which ultimately requires increasing the data capacity and bandwidth of the memory apparatus.

A memory module may include a plurality of memory apparatuses and/or memory packages and may be coupled to the host apparatus through a memory channel formed in a main board. In order to increase the data capacity provided by the memory module, it is necessary to increase the capacity of the plurality of memory apparatuses and/or memory packages mounted on the memory module. For example, the plurality of memory apparatuses and/or memory packages may be implemented as stacked memories using TSV, buffer-chip stacked memories, or stacked memories using wire bonding. However, as the capacity of the plurality of memory apparatuses and/or memory packages increases (that is, as the number of stacked dies constituting the stacked memory increases), data load may increase, operation speed may be limited, and the operation timing may vary for each of the plurality of memory apparatuses mounted on the memory module, which may result in various problems. Therefore, the effective bandwidth between the host apparatus and the memory module may decrease.

### SUMMARY

In an embodiment, a memory module may include a module substrate, a first memory package, a second memory package, and a module controller circuit. The module substrate may include first signal transmission lines and second signal transmission lines. The first memory package may be mounted on a front side of the module substrate and may include a first memory chip accessed by a first chip selection signal and a second memory chip accessed by a second chip selection signal. Data pads of the first memory chip and data pads of the second memory chip may be coupled in common to the first signal transmission lines. The second memory package may be mounted on a rear side of the module substrate and may include a third memory chip accessed by a third chip selection signal and a fourth memory chip accessed by a fourth chip selection signal. Data pads of the third memory chip and data pads of the fourth memory chip may be coupled in common to the second signal transmission lines. The module controller circuit may be mounted on the front side of the module substrate, may be coupled to an external apparatus through a data bus, and may be configured to connect the data bus to one of the first signal transmission lines and the second signal transmission lines based on the first to fourth chip selection signals.

In an embodiment, a memory module may include a module substrate, a memory package, and a module controller circuit. The module substrate may include first signal transmission lines and second signal transmission lines. The memory package may be mounted on the module substrate and may include a first memory chip accessed by a first chip selection signal, a second memory chip accessed by a second chip selection signal, a third memory chip accessed by a third chip selection signal, and a fourth memory chip accessed by a fourth chip selection signal. Data pads of the first memory chip and data pads of the second memory chip may be coupled in common to the first signal transmission lines, and data pads of the third memory chip and data pads of the fourth memory chip may be coupled in common to the second signal transmission lines. The module controller circuit may be mounted on the module substrate, may be coupled to an external apparatus through a data bus, and may be configured to connect the data bus to one of the first and second signal transmission lines based on the first to fourth chip selection signals.

In an embodiment, a memory module may include a module substrate, a first memory package, a second memory package, and a module controller circuit. The module substrate may include first signal transmission lines, second signal transmission lines, third signal transmission lines, and fourth signal transmission lines. The first memory package may be mounted on a front side of the module substrate and may include a first memory chip accessed by a first chip selection signal and a second memory chip accessed by a second chip selection signal. Data pads of the first memory chip may be coupled to first signal transmission lines and data pads of the second memory chip may be coupled to the second signal transmission lines. The second memory package may be mounted on a rear side of the module substrate and may include a third memory chip accessed by a third chip selection signal and a fourth memory chip accessed by a fourth chip selection signal. Data pads of the third memory chip may be coupled to third signal transmission lines and data pads of the fourth memory chip may be coupled to the fourth signal transmission lines. The module controller circuit may be mounted on the front side of the module substrate, may be coupled to an external apparatus through a data bus, and may be configured to connect the data bus to one of the first to fourth signal transmission lines based on the first to fourth chip selection signals.

In an embodiment, a memory module may include a module substrate, a memory package, and a module controller circuit. The module substrate may include first signal transmission lines, second signal transmission lines, third signal transmission lines, and fourth signal transmission lines. The memory package may be mounted on the module substrate and may include a first memory chip accessed by a first chip selection signal, a second memory chip accessed by a second chip selection signal, a third memory chip accessed by a third chip selection signal, and a fourth memory chip accessed by a fourth chip selection signal. Data pads of the first memory chip may be coupled to the first signal transmission lines, data pads of the second memory chip may be coupled to the second signal transmission lines, data pads of the third memory chip may be coupled to the third signal transmission lines, and data pads of the fourth memory chip may be coupled to the fourth signal transmission lines. The module controller circuit may be mounted on the module substrate, may be coupled to an external apparatus through a data bus, and may be configured to connect the data bus to one of the first to fourth signal transmission lines based on the first to fourth chip selection signals.

In an embodiment, a memory module may include a module substrate, a first memory package, a second memory package, and a module controller circuit. The module substrate may include first signal transmission lines and second signal transmission lines. The first memory package may be mounted on a front side of the module substrate and may include a first memory chip accessed by a first chip selection signal and a second memory chip accessed by a second chip selection signal. Data pads of the first memory chip and data pads of the second memory chip may be coupled in common to the first signal transmission lines. The second memory package may be mounted on a rear side of the module substrate and may include a third memory chip accessed by the first chip selection signal and a fourth memory chip accessed by the second chip selection signal. Data pads of the third memory chip and data pads of the fourth memory chip may be coupled in common to the second signal transmission lines. The module controller circuit may be mounted on the front side of the module substrate, may be coupled to an external apparatus through a data bus, and may be configured to, during a write operation, divide data signals received through the data bus and output the divided data signals to the first signal transmission lines and the second signal transmission lines, respectively, and during a read operation, merge data signals received through the first signal transmission lines and the second signal transmission lines and output the merged data signals to the data bus.

### BRIEF DESCRIPTION OF THE DRAWINGS

FIG. 1 is a diagram illustrating a configuration of a memory module according to an embodiment of the present disclosure.
FIG. 2A is a diagram illustrating at least a part of a configuration of a memory module according to an embodiment of the present disclosure.
FIG. 2B is a diagram illustrating at least a part of a configuration of a memory module according to an embodiment of the present disclosure.
FIG. 3 is a diagram illustrating a configuration of a data control circuit according to an embodiment of the present disclosure.
FIG. 4A is a diagram illustrating at least part of a configuration of a memory module according to an embodiment of the present disclosure.
FIG. 4B is a diagram illustrating at least a part of a configuration of a memory module according to an embodiment of the present disclosure.
FIG. 5 is a diagram illustrating a configuration of a data control circuit according to an embodiment of the present disclosure.
FIG. 6 is a diagram illustrating a configuration of a memory module according to an embodiment of the present disclosure.
FIG. 7A is a diagram illustrating a configuration of a memory module according to an embodiment of the present disclosure, and FIG. 7B is a timing diagram illustrating an operation of a memory module according to an embodiment of the present disclosure.
FIG. 8 is a diagram illustrating at least a part of a configuration of a memory module according to an embodiment of the present disclosure.
FIG. 9A is a diagram illustrating a configuration of the data control circuit illustrated in FIG. 8, and FIG. 9B is a timing diagram illustrating an operation of the data control circuit.
FIG. 10 is a diagram illustrating a configuration of a memory module according to an embodiment of the present disclosure.
FIG. 11 is a timing diagram illustrating an operation of a memory module according to an embodiment of the present disclosure.
FIG. 12 is a timing diagram illustrating an operation of a memory module according to an embodiment of the present disclosure.
FIG. 13 is a diagram illustrating a configuration of a memory module according to an embodiment of the present disclosure.
FIG. 14A is a diagram illustrating a configuration of a computing system according to an embodiment of the present disclosure.
FIG. 14B is a diagram illustrating a configuration of a computing system according to an embodiment of the present disclosure.

### DETAILED DESCRIPTION

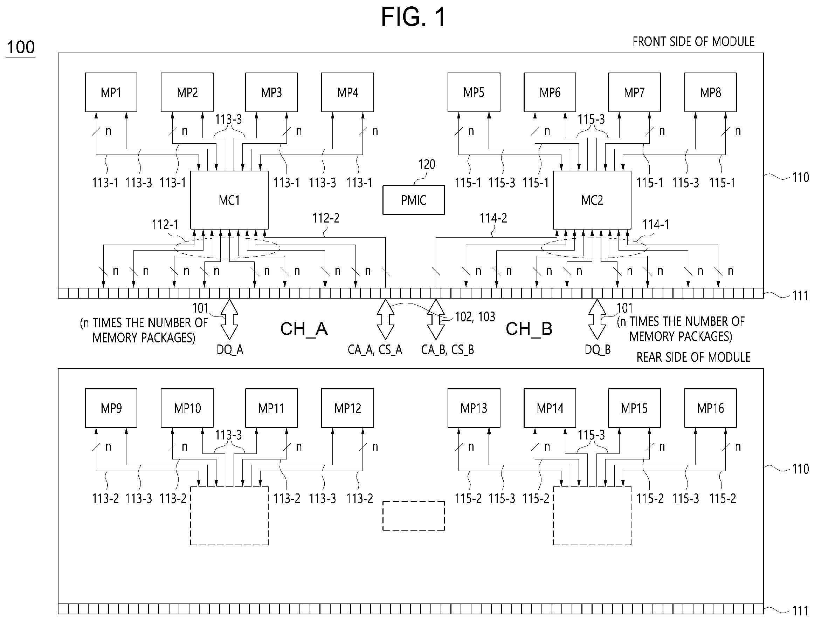

FIG. 1 is a diagram illustrating a configuration of a memory module 100 according to an embodiment of the present disclosure. In some embodiments, the memory module has a DIMM form factor. Referring to FIG. 1, the memory module 100 may include a module substrate 110. In some embodiments, the module substrate can be a printed circuit board (PCB). At least one module controller circuit and a plurality of memory packages may be mounted on the module substrate 110. The module substrate 110 may include a plurality of module pins 111 and may communicate with an external apparatus (not shown) through the module pins 111. The external apparatus may be a host apparatus such as a central processing unit (CPU) or a graphic processing unit (GPU) or a Computer Express Link (CXL) controller. The at least one module controller circuit may mediate communication between the external apparatus and the plurality of memory packages. The memory module 100 may include a plurality of sub-channels. The sub-channel may represent a unit that can independently perform data input/output operations. For example, the memory module 100 may include a first sub-channel CH_A and a second sub-channel CH_B, and the number of the module controllers circuit may be substantially the same as the number of sub-channels included in the memory module 100.

The memory module 100 may include first to sixteenth memory packages MP1-MP16, a first module controller circuit MC1, and a second module controller circuit MC2. The first to sixteenth memory packages MP1-MP16 may each include a plurality of memory chips. For example, the first to sixteenth memory packages MP1-MP16 may each include two or four memory chips. Each memory chip may include any one of DDR4, DDR5, DDR6, or processing in memory (PIM). The first to fourth memory packages MP1-MP4, the ninth to twelfth memory packages MP9-MP12, and the first module controller circuit MC1 may constitute the first sub-channel CH_A, and the fifth to eighth memory packages MP5-MP8, the thirteenth to sixteenth memory packages MP13-MP16, and the second module controller circuit MC2 may constitute the second sub-channel CH_B. In FIG. 1, the number of memory packages constituting one sub-channel coupled to one module controller circuit is exemplified as eight. However, the present disclosure is not limited thereto, and the number of memory packages constituting one sub-channel may be less than or more than eight. The first memory package MP1 may be mounted at a first position on the front side of the memory module 100. The second memory package MP2 may be mounted at a second position on the front side of the memory module 100. The third memory package MP3 may be mounted at a third position on the front side of the memory module 100. The fourth memory package MP4 may be mounted at a fourth position on the front side of the memory module 100. The first module controller circuit MC1 may be mounted at a fifth position on the front side of the memory module 100. The first to fifth positions might not overlap each other. The ninth memory package MP9 may be mounted at a first position on the rear side of the memory module 100. The rear side of the memory module 100 may be opposite to the front side of the memory module 100. The tenth memory package MP10 may be mounted at a second position on the rear side of the memory module 100. The eleventh memory package MP11 may be mounted at a third position on the rear side of the memory module 100. The twelfth memory package MP12 may be mounted at a fourth position on the rear side of the memory module 100. The first to fourth positions on the front side of the memory module 100 may face the first to fourth positions on the rear side and the same numbered positions may overlap respectively in the thickness direction. The fifth memory package MP5 may be mounted at a sixth position on the front side of the memory module. The sixth memory package MP6 may be mounted at a seventh position on the front side of the memory module. The seventh memory package MP7 may be mounted at an eighth position on the front side of the memory module 100. The eighth memory package MP8 may be mounted at a ninth position on the front side of the memory module 100. The second module controller circuit MC2 may be mounted at a tenth position on the front side of the memory module 100. The sixth to tenth positions might not overlap each other. The thirteenth memory package MP13 may be mounted at a sixth position on the rear side of the memory module 100. The fourteenth memory package MP 14 may be mounted at a seventh position on the rear side of the memory module 100. The fifteenth memory package MP15 may be mounted at an eighth position on the rear side of the memory module. The sixteenth memory package MP16 may be mounted at a ninth position on the rear side of the memory module 100. The sixth to ninth positions on the front side of the memory module 100 may face the sixth to ninth positions on the rear side, and the same numbered positions may overlap respectively in the thickness direction.

The first module controller circuit MC1 may be coupled to the module pins 111, the first to fourth memory packages MP1-MP4, and the ninth to twelfth memory packages MP9-MP12 through signal transmission lines formed in the module substrate 110. The first module controller circuit MC1 may receive data signals DQ_A of the first sub-channel CH_A from the external apparatus and may transmit the data signals DQ_A of the first sub-channel CH_A to the external apparatus through the module pins 111 and signal transmission lines 112-1. The first module controller circuit MC1 may receive a command address signal CA_A and a chip selection signal CS_A of the first sub-channel CH_A from the external apparatus through the module pins 111 and signal transmission lines 112-2. The first module controller circuit MC1 may transmit the data signals DQ_A of the first sub-channel CH_A to the first to fourth memory packages MP1-MP4 and the ninth to twelfth memory packages MP9-MP12 and may receive data signals transmitted from the first to fourth memory packages MP1-MP4 and the ninth to twelfth memory packages MP9-MP12 through signal transmission lines 113-1 and 113-2. The first module controller circuit MC1 may transmit the command address signal CA_A and the chip selection signal CS_A of the first sub-channel CH_A to the first to fourth memory packages MP1-MP4 and the ninth to twelfth memory packages MP9-MP12 through signal transmission lines 113-3. The second module controller circuit MC2 may be coupled to the module pins 111, the fifth to eighth memory packages MP5-MP8, and the thirteenth to sixteenth memory packages MP13-MP16 through signal transmission lines formed in the module substrate 110. The second module controller circuit MC2 may receive data signals DQ_B of the second sub-channel CH_B from the external apparatus and may transmit the data signals DQ_B of the second sub-channel CH_B to the external apparatus through the module pins 111 and signal transmission lines 114-1. The second module controller circuit MC2 may receive a command address signal CA_B and a chip selection signal CS_B of the second sub-channel CH_B from the external apparatus through the module pins 111 and signal transmission lines 114-2. The second module controller circuit MC2 may transmit the data signals DQ_B of the second sub-channel CH_B to the fifth to eighth memory packages MP5-MP8 and the thirteenth to sixteenth memory packages MP13-MP16 and may receive data signals transmitted from the fifth to eighth memory packages MP5-MP8 and the thirteenth to sixteenth memory packages MP13-MP16 through signal transmission lines 115-1 and 115-2. The second module controller circuit MC2 may transmit the command address signal CA_B and the chip selection signal CS_B of the second sub-channel CH_B to the fifth to eighth memory packages MP5-MP8 and the thirteenth to sixteenth memory packages MP13-MP16 through signal transmission lines 115-3.

The module pins 111 may be coupled to the external apparatus through a data bus 101. The number of signal transmission lines included in the data bus 101 may be n times the number of memory packages included in the memory module. Here, n may be a multiple of 4 or a multiple of 6. For example, the number of signal transmission lines included in data bus transmitting the data signals DQ_A of the first sub-channel CH_A may be n×8, and the number of signal transmission lines included in data bus transmitting the data signals of the second sub-channel CH_B may also be n×8. The module pins 111 may be coupled to the external apparatus through a command address bus 102 and a chip selection bus 103. The memory module 100 may receive the command address signals CA_A of the first sub-channel CH_A and the command address signals CA_B of the second sub-channel CH_B through the command address bus 102, and may receive the chip selection signals CS_A of the first sub-channel CH_A and the chip selection signals CS_B of the second sub-channel CH_B through the chip selection bus 103. The number of signal transmission lines transmitting the data signals DQ_A of the first sub-channel CH_A between the module pins 111 and the first module controller circuit MC1 among the signal transmission lines formed in the module substrate 110 may be n×8. The number of signal transmission lines transmitting the data signals DQ_B of the second sub-channel CH_B between the module pins 111 and the second module controller circuit MC2 may be n×8. The first module controller circuit MC1 may be coupled to the first to fourth memory packages MP1-MP4 and the ninth to twelfth memory packages MP9-MP12 through n signal transmission lines, respectively, to transmit and receive data signals. The second module controller circuit MC2 may be coupled to the fifth to eighth memory packages MP5-MP8 and the thirteenth to sixteenth memory packages MP13-MP16 through n signal transmission lines, respectively, to transmit and receive data signals. In an embodiment, the module pins 111 may receive a parity signal and metadata through the data bus 101, and one of the memory packages of each sub-channel may store and output the parity signal and the metadata. For example, the memory module 100 may receive the parity signal and the metadata through n signal transmission lines among the data bus 101 of the first sub-channel CH_A. The first module controller circuit MC1 may transmit the parity signal and the metadata to one of the first to fourth memory packages MP1-MP4 and the ninth to twelfth memory packages MP9-MP12. The memory module 100 may receive a parity signal and metadata through n signal transmission lines among the data bus 101 of the second sub-channel CH_B. The second module controller circuit MC2 may transmit the parity signal and the metadata to one of the fifth to eighth memory packages MP5-MP8 and the thirteenth to sixteenth memory packages MP13-MP16.

The memory module 100 may further include a power management integrated circuit (PMIC) 120. The power management integrated circuit 120 may be mounted on the front side of the module substrate 110. The power management integrated circuit 120 may receive power from a power supply (not shown). The power management integrated circuit 120 may generate various power voltages based on the power. The power management integrated circuit 120 may supply the various power voltages to the first and second module controller circuits MC1 and MC2 and the first to sixteenth memory packages MP1-MP16, respectively. The first and second module controller circuits MC1 and MC2 may each operate by receiving at least one power voltage from the power management integrated circuit 120. The first to sixteenth memory packages MP1-MP16 may operate by receiving at least one power voltage from the power management integrated circuit 120. Although not shown, the power management integrated circuit 120 may receive the power from the power supply through the module pins 111 and power lines formed in the module substrate 110. The power management integrated circuit 120 may supply the various power voltages to the first and second module controller circuits MC1 and MC2 and the first to sixteenth memory packages MP1-MP16 through a plurality of power lines formed in the module substrate 110.

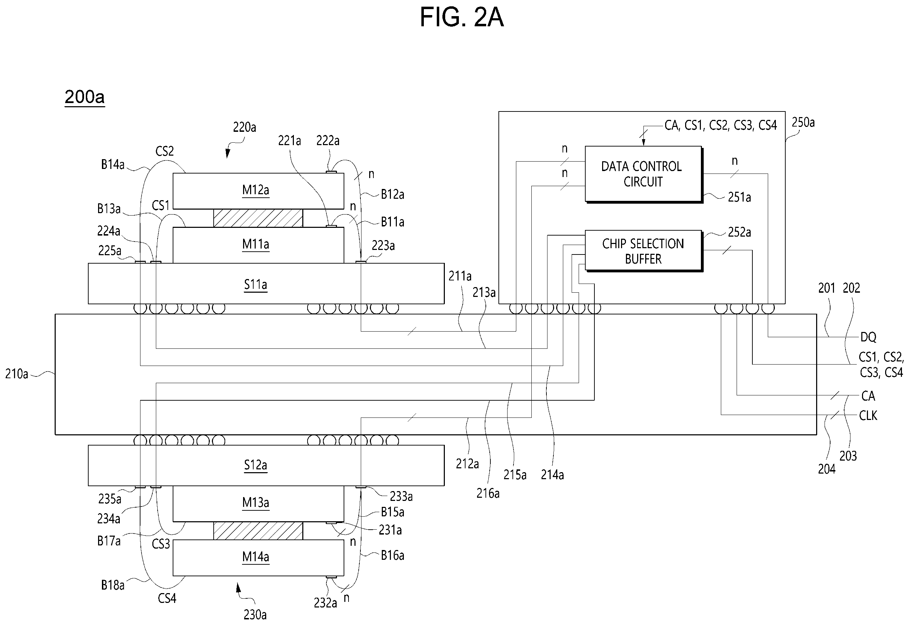

FIG. 2A is a diagram illustrating at least a part of a configuration of a memory module 200a according to an embodiment of the present disclosure. Referring to FIG. 2A, the memory module 200a may include a module substrate 210a, a first memory package 220a, a second memory package 230a, and a module controller circuit 250a. The first memory package 220a and second memory package 230a may face each other across the module substrate 210a and may correspond to the first and ninth memory packages MP1 and MP9 illustrated in FIG. 1, for example. The module controller circuit 250a may correspond to the first module controller circuit MC1. The module substrate 210a may include first signal transmission lines 211a and second signal transmission lines 212a. The module substrate 210a may further include a third signal transmission line 213a, a fourth signal transmission line 214a, a fifth signal transmission line 215a, and a sixth signal transmission line 216a. The first memory package 220a may be mounted on a front side (an upper side of the module substrate 210a in FIG. 2A) of the module substrate 210a. The second memory package 230a may be mounted on a rear side (a lower side of the module substrate 210a in FIG. 2A) of the module substrate 210a. The first and second memory packages 220a and 230a may be double-die packages (DDPs), each including two memory chips.

The first memory package 220a may include a first memory chip M11a and a second memory chip M12a. The first memory chip M11a may receive a first chip selection signal CS1 and may be accessed based on the first chip selection signal CS1. Some of the CS signals shown on FIG. 2A and other figures are disposed next to their respective bonding wires as described below. The second memory chip M12a may receive a second chip selection signal CS2 and may be accessed based on the second chip selection signal CS2. The first and second memory chips M11a and M12a may each include data pads 221a and 222a, respectively. The data pads 221a of the first memory chip M11a and the data pads 222a of the second memory chip M12a may be coupled in common to the first signal transmission lines 211a. The second memory package 230a may include a third memory chip M13a and a fourth memory chip M14a. The third memory chip M13a may receive a third chip selection signal CS3 and may be accessed based on the third chip selection signal CS3. The fourth memory chip M14a may receive a fourth chip selection signal CS4 and may be accessed based on the fourth chip selection signal CS4. The third and fourth memory chips M13a and M14a may each include data pads 231a and 232a, respectively. The data pads 231a of the third memory chip M13a and the data pads 232a of the fourth memory chip M14a may be coupled in common to the second signal transmission lines 212a.

The module controller circuit 250a may be mounted on the front side of the module substrate 210a. The module controller circuit 250a may be coupled to an external apparatus through a data bus 201. The module controller circuit 250a may be coupled to the data bus 201 through the signal transmission lines formed in the module substrate 210a. The module controller circuit 250a may receive data signals DQ from the external apparatus through the data bus 201 and may output the data signals DQ to the external apparatus. The module controller circuit 250a may receive the first to fourth chip selection signals CS1-CS4. The module controller circuit 250a may connect the data bus 201 to one of the first and second signal transmission lines 211a and 212a based on the first to fourth chip selection signals CS1-CS4. For example, the module controller circuit 250a may connect the data bus 201 to the first signal transmission lines 211a when either the first or second chip selection signal CS1 or CS2 is asserted, and may connect the data bus 201 to the second signal transmission lines 212a when either the third or fourth chip selection signal CS3 or CS4 is asserted. The external apparatus may provide the first to fourth chip selection signals CS1-CS4 to access the first to fourth memory chips M11a-M14a, but the data bus 201 might not be directly coupled to the first to fourth memory chips M1 1a-M14a and may be coupled to the first to fourth memory chips M11aM14a through the module controller circuit 250a. The module controller circuit 250a may connect only one of the first and second signal transmission lines 211a and 212a to the data bus 201 based on the first to fourth chip selection signals CS1-CS4. Therefore, the data bus 201 may only encounter a single chip (that is, the module controller circuit), and the first and second signal transmission lines may each encounter only the load of two memory chips. Consequently, the load encountered by the external apparatus toward the memory module 200a and the load between the module controller circuit 250a and the memory packages may be efficiently reduced, mitigating a reduction in operation speed between the external apparatus and the memory module 200a and improving data signal integrity. When the module controller circuit 250a reduces the loading, the memory package may have a structure that electrically connects the memory chips using bonding wires, which can greatly reduce the manufacturing cost of the memory package. The number of signal transmission lines included in the data bus 201 may be substantially the same as the number of the first and second signal transmission lines 211a and 212a, respectively. The data signals DQ transmitted through the data bus 201 may be transmitted entirely through one of the first and second signal transmission lines 211a and 212a. For example, the number of signal transmission lines included in the data bus 201 and the numbers of the first and second signal transmission lines 211a and 212a may each be n.

The module controller circuit 250a may be coupled to the third to sixth signal transmission lines 213a to 216a. The module controller circuit 250a may be coupled to a chip selection bus 202 through signal transmission lines formed in the module substrate 210a and may receive the first to fourth chip selection signals CS1-CS4 from the external apparatus through the chip selection bus 202. The module controller circuit 250a may buffer the first to fourth chip selection signals CS1-CS4 and may transmit the buffered first to fourth chip selection signals CS1-CS4 to the first and second memory packages 220a and 230a through the third to sixth signal transmission lines 213a to 216a, respectively. The module controller circuit 250a may be coupled to a command address bus 203 through signal transmission lines formed in the module substrate 210a and may receive a command address signal CA from the external apparatus through the command address bus 203. Although not shown, the module controller circuit 250a may buffer the command address signal CA and may transmit the buffered command address signal CA to the first and second memory packages 220a and 230a, respectively. The module controller circuit 250a may be coupled to a clock bus 204 through signal transmission lines formed in the module substrate 210a and may receive a clock signal CLK from the external apparatus through the clock bus 204. Although not shown, the module controller circuit 250a may buffer the clock signal CLK and may transmit the buffered clock signal CLK to the first and second memory packages 220a and 230a, respectively. The module controller circuit 250a may buffer the clock signal CLK transmitted from the first and second memory packages 220a and 230a and may output the buffered clock signal CLK to the external apparatus through the clock bus 204.

The first memory package 220a may include a first package substrate S11a. The first package substrate S11a may be mounted on a front side of the module substrate 210a. The first memory chip M11a may be disposed on the first package substrate S11a, and the second memory chip M12a may be disposed on the first memory chip M11a. The first memory chip M11a may be bonded to the first package substrate S11a, and the second memory chip M12a may be bonded to the first memory chip M11a using a die attach film (DAF). The first package substrate S11a may include first pads 223a. The first pads 223a may be coupled to the first signal transmission lines 211a. The first pads 223a may be coupled to the first signal transmission lines 211a through package balls of the first package substrate S11a. The data pads 221a of the first memory chip M11a and the data pads 222a of the second memory chip M12a may be coupled in common to the first pads 223a. The data pads 221a of the first memory chip M11a may be connected to the first pads 223a through first bonding wires B11a. The data pads 222a of the second memory chip M12a may be connected to the first pads 223a through second bonding wires B12a. The first package substrate S11a may further include a second pad 224a and a third pad 225a. The second pad 224a may be coupled to the third signal transmission line 213a and may receive the first chip selection signal CS1 transmitted from the module controller circuit 250a through the third signal transmission line 213a. The third pad 225a may be coupled to the fourth signal transmission line 214a and may receive the second chip selection signal CS2 transmitted from the module controller circuit 250a through the fourth signal transmission line 214a. The second and third pads 224a and 225a may be respectively coupled to the third and fourth signal transmission lines 213a and 214a through package balls of the first package substrate S11a. The first memory chip M11a may receive the first chip selection signal CS1 through the third signal transmission line 213a and the second pad 224a. The first memory chip M11a may be connected to the second pad 224a through a third bonding wire B13a. The second memory chip M12a may receive the second chip selection signal CS2 through the fourth signal transmission line 214a and the third pad 225a. The second memory chip M12a may be connected to the third pad 225a through a fourth bonding wire B14a.

The second memory package 230a may include a second package substrate S12a. The second package substrate S 12a may be mounted on a rear side of the module substrate 210a. The third memory chip M13a may be disposed on the second package substrate S12a, and the fourth memory chip M14a may be disposed on the third memory chip M13a. The third memory chip M13a may be bonded to the second package substrate S12a, and the fourth memory chip M14a may be bonded to the third memory chip M13a using DAF. The second package substrate S12a may include fourth pads 233a. The fourth pads 233a may be coupled to the second signal transmission lines 212a. The fourth pads 233a may be coupled to the second signal transmission lines 212a through package balls of the second package substrate S12a. The data pads 231a of the third memory chip M13a and the data pads 232a of the fourth memory chip M14a may be coupled in common to the fourth pads 233a. The data pads 231a of the third memory chip M13a may be connected to the fourth pads 233a through fifth bonding wires B15a. The data pads 232a of the fourth memory chip M14a may be connected to the fourth pads 233a through sixth bonding wires B16a. The second package substrate S12a may further include a fifth pad 234a and a sixth pad 235a. The fifth pad 234a may be coupled to the fifth signal transmission line 215a and may receive the third chip selection signal CS3 transmitted from the module controller circuit 250a through the fifth signal transmission line 215a. The sixth pad 235a may be coupled to the sixth signal transmission line 216a and may receive the fourth chip selection signal CS4 transmitted from the module controller circuit 250a through the sixth signal transmission line 216a. The fifth and sixth pads 234a and 235a may be respectively coupled to the fifth and sixth signal transmission lines 215a and 216a through package balls of the second package substrate S12a. The third memory chip M13a may receive the third chip selection signal CS3 through the fifth signal transmission line 215a and the fifth pad 234a. The third memory chip M13a may be connected to the fifth pad 234a through a seventh bonding wire B17a. The fourth memory chip M14a may receive the fourth chip selection signal CS4 through the sixth signal transmission line 216a and the sixth pad 235a. The fourth memory chip M14a may be connected to the sixth pad 235a through an eighth bonding wire B18a.

The module controller circuit 250a may include a data control circuit 251a and a chip selection buffer 252a. The data control circuit 251a may receive the first to fourth chip selection signals CS1-CS4 and may connect the data bus 201 to one of the first and second signal transmission lines 211a and 212a based on the first to fourth chip selection signals CS1-CS4. The data control circuit 251a may connect the data bus 201 to the first signal transmission lines 211a to form a data path between the first memory package 220a and the data bus 201 when either the first or second chip selection signal CS1 or CS2 is asserted. The data control circuit 251a may connect the data bus 201 to the second signal transmission lines 212a to form a data path between the second memory package 230a and the data bus 201 when either the third or fourth chip selection signal CS3 or CS4 is asserted. The data control circuit 251a may further receive the command address signal CA. The data control circuit 251a may form a data path from the data bus 201 to one of the first and second signal transmission lines 211a and 212a or form a data path from one of the first and second signal transmission lines 211a and 212a to the data bus 201, based on the command address signal CA. The chip selection buffer 252a may receive the first to fourth chip selection signals CS1-CS4 through the chip selection bus 202. The chip selection buffer 252a may buffer the first to fourth chip selection signals CS1-CS4 and may transmit the buffered first to fourth chip selection signals CS1-CS4 to the first to fourth memory chips M11a-M14a, respectively. The chip selection buffer 252a may output the first chip selection signal CS1 to the third signal transmission line 213a, the second chip selection signal CS2 to the fourth signal transmission line 214a, the third chip selection signal CS3 to the fifth signal transmission line 215a, and the fourth chip selection signal CS4 to the sixth signal transmission line 216a.

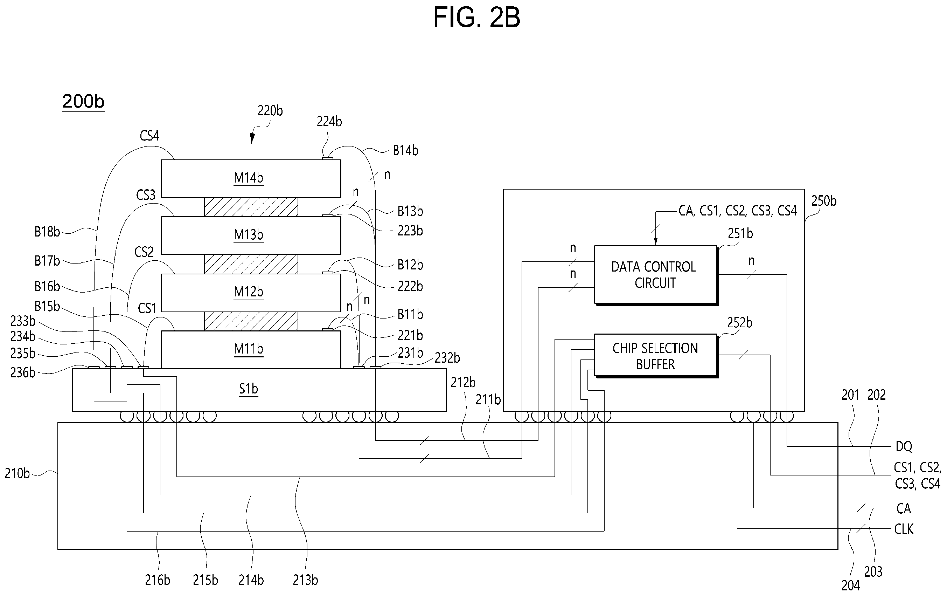

FIG. 2B is a diagram illustrating at least a part of a configuration of a memory module 200b according to an embodiment of the present disclosure. Referring to FIG. 2B, the memory module 200b may include a module substrate 210b, a memory package 220b, and a module controller circuit 250b. The memory package 220b may correspond to any one of the first to fourth memory packages MP1-MP4 and the ninth to twelfth memory packages MP9-MP12 illustrated in FIG. 1, for example, and the module controller circuit 250b may correspond to the first module controller circuit MC1. The module substrate 210b may include first signal transmission lines 211b and second signal transmission lines 212b. The module substrate 210b may further include a third signal transmission line 213b, a fourth signal transmission line 214b, a fifth signal transmission line 215b, and a sixth signal transmission line 216b. The memory package 220b may be mounted on the module substrate 210b. The memory package 220b may be a quad-die package (QDP) including four memory chips.

The memory package 220b may include a first memory chip M11b, a second memory chip M12b, a third memory chip M13b, and a fourth memory chip M14b. The first memory chip M11b may receive a first chip selection signal CS1 and may be accessed based on the first chip selection signal CS1. The second memory chip M12b may receive a second chip selection signal CS2 and may be accessed based on the second chip selection signal CS2. The third memory chip M13b may receive a third chip selection signal CS3 and may be accessed based on the third chip selection signal CS3. The fourth memory chip M14b may receive a fourth chip selection signal CS4 and may be accessed based on the fourth chip selection signal CS4. The first to fourth memory chips M11b-M14b may each include data pads 231b, 232b, 233b, and 234b, respectively. The data pads 221b of the first memory chip M11b and the data pads 222b of the second memory chip M12b may be coupled in common to the first signal transmission lines 211b. The data pads 223b of the third memory chip M13b and the data pads 224b of the fourth memory chip M14b may be coupled in common to the second signal transmission lines 212b.

The module controller circuit 250b may be mounted on the module substrate 210b. The module controller circuit 250b may be coupled to an external apparatus through a data bus 201. The module controller circuit 250b may be coupled to the data bus 201 through signal transmission lines formed in the module substrate 210b. The module controller circuit 250b may receive data signals DQ from the external apparatus through the data bus 201 and may output the data signals DQ to the external apparatus. The module controller circuit 250b may receive the first to fourth chip selection signals CS1-CS4. The module controller circuit 250b may connect the data bus 201 to one of the first and second signal transmission lines 211b and 212b based on the first to fourth chip selection signals CS1-CS4. For example, the module controller circuit 250b may connect the data bus 201 to the first signal transmission lines 211b when either the first or second chip selection signal CS1 or CS2 is asserted. The module controller circuit 250b may connect the data bus 201 to the second signal transmission lines 212b when either the third or fourth chip selection signal CS3 or CS4 is asserted. The external apparatus may access the first to fourth memory chips M11b-M14b according to the first to fourth chip selection signals CS1-CS4, but the data bus 201 might not be directly coupled to the first to fourth memory chips M11b-M14b and may be coupled to the first to fourth memory chips M11b-M14b through the module controller circuit 250b. The module controller circuit 250b may connect only one of the first and second signal transmission lines 211b and 212b to the data bus 201 based on the first to fourth chip selection signals CS1-CS4. Therefore, the data bus 201 may only encounter the loading of a single chip (that is, the module controller circuit), and the first and second signal transmission lines 211b and 212b may each encounter only the loading of two memory chips. Consequently, the loading encountered by the external apparatus toward the memory module 200b and the loading between the module controller circuit 250b and the memory package 220b may be efficiently reduced, alleviating a reduction in operation speed between the external apparatus and the memory module 200b and improving data signal integrity. When the module controller circuit 250b reduces the loading, the memory package may have a structure in which the memory chips are electrically coupled using bonding wires, which can greatly reduce the manufacturing cost of the memory package. The number of signal transmission lines included in the data bus 201 may be substantially the same as the number of the first and second signal transmission lines 211b and 212b, respectively. The data signals DQ transmitted through the data bus 201 may be transmitted entirely through one of the first and second signal transmission lines 211b and 212b. For example, the number of signal transmission lines included in the data bus 201 and the numbers of the first and second signal transmission lines 211b and 212b may each be n.

The module controller circuit 250b may be coupled to the third to sixth signal transmission lines 213b to 216b. The module controller circuit 250b may be coupled to a chip selection bus 202 through signal transmission lines formed in the module substrate 210b and may receive the first to fourth chip selection signals CS1-CS4 from the external apparatus through the chip selection bus 202. The module controller circuit 250b may buffer the first to fourth chip selection signals CS1-CS4 and may transmit the buffered first to fourth chip selection signals CS1-CS4 to the memory package 220b through the third to sixth signal transmission lines 213b to 216b. The module controller circuit 250b may be coupled to a command address bus 203 through signal transmission lines formed in the module substrate 210b and may receive a command address signal CA from the external apparatus through the command address bus 203. The module controller circuit 250b may be coupled to a clock bus 204 through signal transmission lines formed in the module substrate 210b and may receive a clock signal CLK from the external apparatus through the clock bus 204 or may transmit the clock signal CLK to the external apparatus.

The memory package 220b may include a package substrate S1b. The package substrate S1b may be mounted on the module substrate 210b. The first memory chip M11b may be disposed on the package substrate S1b, and the second memory chip M12b may be disposed on the first memory chip M11b. The third memory chip M13b may be disposed on the second memory chip M12b, and the fourth memory chip M14b may be disposed on the third memory chip M13b. The first memory chip M11b may be bonded to the package substrate S1b, and the second to fourth memory chips M12b-M14b may be bonded to the first to third memory chips M11b-M13b, respectively, using a die attach film (DAF) represented by a rectangle having hatching. The package substrate S1b may include first pads 231b and second pads 232b. The first pads 231b may be coupled to the first signal transmission lines 211b. The second pads 232b may be coupled to the second signal transmission lines 212b. The first and second pads 231b and 232b may be respectively coupled to the first and second signal transmission lines 211b and 212b through package balls of the package substrate S1b. The data pads 221b of the first memory chip M11b and the data pads 222b of the second memory chip M12b may be coupled in common to the first pads 231b. The data pads 221b of the first memory chip M11b may be connected to the first pads 231b through first bonding wires B11b. The data pads 222b of the second memory chip M12b may be connected to the first pads 231b through second bonding wires B12b. The data pads 223b of the third memory chip M13b and the data pads 224b of the fourth memory chip M14b may be coupled in common to the second pads 232b. The data pads 223b of the third memory chip M13b may be connected to the second pads 232b through third bonding wires B13b. The data pads 224b of the fourth memory chip M14b may be connected to the second pads 232b through fourth bonding wires B14b. The package substrate S1b may further include a third pad 233b, a fourth pad 234b, a fifth pad 235b, and a sixth pad 236b. The third pad 233b may be coupled to the third signal transmission line 213b and may receive the first chip selection signal CS1 transmitted from the module controller circuit 250b through the third signal transmission line 213b. The fourth pad 234b may be coupled to the fourth signal transmission line 214b and may receive the second chip selection signal CS2 transmitted from the module controller circuit 250b through the fourth signal transmission line 214b. The fifth pad 235b may be coupled to the fifth signal transmission line 215b and may receive the third chip selection signal CS3 transmitted from the module controller circuit 250b through the fifth signal transmission line 215b. The sixth pad 236b may be coupled to the sixth signal transmission line 216b and may receive the fourth chip selection signal CS4 transmitted from the module controller circuit 250b through the sixth signal transmission line 216b. The third to sixth pads 233b-236b may be respectively coupled to the third to sixth signal transmission lines 213b-216b through package balls of the package substrate S1b. The first memory chip M11b may receive the first chip selection signal CS1 through the third signal transmission line 213b and the third pad 233b. The first memory chip M11b may be connected to the third pad 233b through a fifth bonding wire B15b. The second memory chip M12b may receive the second chip selection signal CS2 through the fourth signal transmission line 214b and the fourth pad 234b. The second memory chip M12b may be connected to the fourth pad 234b through a sixth bonding wire B16b. The third memory chip M13b may receive the third chip selection signal CS3 through the fifth signal transmission line 215b and the fifth pad 235b. The third memory chip M13b may be connected to the fifth pad 235b through a seventh bonding wire B 17b. The fourth memory chip M14b may receive the fourth chip selection signal CS4 through the sixth signal transmission line 216b and the sixth pad 236b. The fourth memory chip M14b may be connected to the sixth pad 236b through an eighth bonding wire B18b.

The module controller circuit 250b may include a data control circuit 251b and a chip selection buffer 252b. The data control circuit 251b may receive the first to fourth chip selection signals CS1-CS4 and may connect the data bus 201 to one of the first and second signal transmission lines 211b and 212b based on the first to fourth chip selection signals CS1-CS4. The data control circuit 251b may connect the data bus 201 to the first signal transmission lines 211b to form a data path between the first and second memory chips M11b and M12b and the data bus 201 when either the first or second chip selection signal CS1 or CS2 is asserted. The data control circuit 251b may connect the data bus 201 to the second signal transmission lines 212b to form a data path between the third and fourth memory chips M13b and M14b and the data bus 201 when either the third or fourth chip selection signal CS3 or CS4 is asserted. The data control circuit 251b may further receive the command address signal CA. The data control circuit 251b may form a data path from the data bus 201 to one of the first and second signal transmission lines 211b and 212b or form a data path from one of the first and second signal transmission lines 211b and 212b to the data bus 201, based on the command address signal CA. The chip selection buffer 252b may receive the first to fourth chip selection signals CS1-CS4 through the chip selection bus 202. The chip selection buffer 252b may buffer the first to fourth chip selection signals CS1-CS4 and may transmit the buffered first to fourth chip selection signals CS1-CS4 to the first to fourth memory chips M11b-M14b, respectively. The chip selection buffer 252b may output the first chip selection signal CS1 to the third signal transmission line 213b, the second chip selection signal CS2 to the fourth signal transmission line 214b, the third chip selection signal CS3 to the fifth signal transmission line 215b, and the fourth chip selection signal CS4 to the sixth signal transmission line 216b.

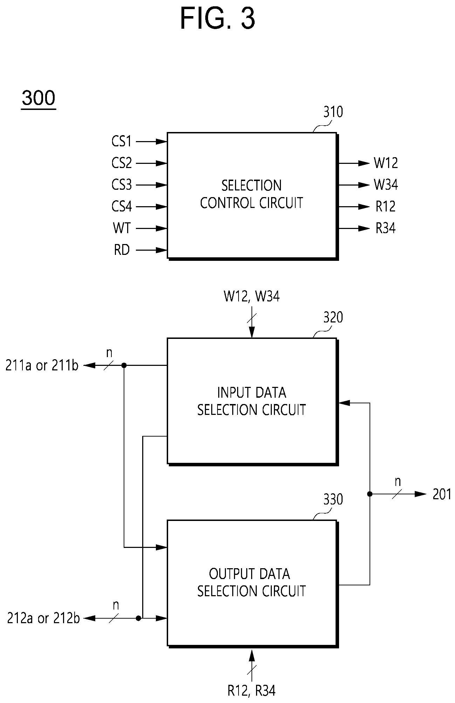

FIG. 3 is a diagram illustrating a configuration of a data control circuit 300 according to an embodiment of the present disclosure. The data control circuits 251a and 251b illustrated in FIGS. 2A and 2B may each be implemented as the data control circuit 300. Referring to FIG. 3, the data control circuit 300 may include a selection control circuit 310, an input data selection circuit 320, and an output data selection circuit 330. The selection control circuit 310 may receive the first to fourth chip selection signals CS1-CS4, a write signal WT, and a read signal RD. The write signal WT may be generated based on the command address signal CA that indicates a write operation of the memory module 200a or 200b. The write operation may refer to an operation in which the memory module 200a or 200b receives data from the external apparatus. The read signal RD may be generated based on the command address signal CA that indicates a read operation of the memory module 200a or 200b. The read operation may refer to an operation in which the memory module 200a or 200b transmits data to the external apparatus. The selection control circuit 310 may generate a first input selection signal W12, a second input selection signal W34, a first output selection signal R12, and a second output selection signal R34 based on the first to fourth chip selection signals CS1-CS4, the write signal WT, and the read signal RD. The selection control circuit 310 may enable the first input selection signal W12 when the write signal WT is asserted and either the first or second chip selection signal CS1 or CS2 is asserted. The selection control circuit 310 may enable the second input selection signal W34 when the write signal WT is asserted and either the third or fourth chip selection signal CS3 or CS4 is asserted. The selection control circuit 310 may enable the first output selection signal R12 when the read signal RD is asserted and either the first or second chip selection signal CS1 or CS2 is asserted. The selection control circuit 310 may enable the second output selection signal R34 when the read signal RD is asserted and either the third or fourth chip selection signal CS3 or CS4 is asserted.

The input data selection circuit 320 may be coupled between the data bus 201 and the first signal transmission lines 211a or 211b and between the data bus 201 and the second signal transmission lines 212a or 212b. The input data selection circuit 320 may receive the first and second input selection signals W12 and W34. The input data selection circuit 320 may connect the data bus 201 to one of the first signal transmission lines 211a or 211b and the second signal transmission lines 212a or 212b based on the first and second input selection signals W12 and W34. When the first input selection signal W12 is enabled, the input data selection circuit 320 may connect the data bus 201 to the first signal transmission lines 211a or 211b. The data signals DQ received through the data bus 201 may be transmitted through the first signal transmission lines 211a or 211b to either the first memory chip M11a or M11b or the second memory chip M12a or M12b. When the second input selection signal W34 is enabled, the input data selection circuit 320 may connect the data bus 201 to the second signal transmission lines 212a or 212b. The data signals received through the data bus 201 may be transmitted through the second signal transmission lines 212a or 212b to either the third memory chip M13a or M13b or the fourth memory chip M14a or M14b.

The output data selection circuit 330 may be coupled between the data bus 201 and the first signal transmission lines 211a or 211b and between the data bus 201 and the second signal transmission lines 212a or 212b. The output data selection circuit 330 may receive the first and second output selection signals R12 and R34. The output data selection circuit 330 may connect the data bus 201 to one of the first signal transmission lines 211a or 211b and the second signal transmission lines 212a or 212b based on the first and second output selection signals R12 and R34. When the first output selection signal R12 is enabled, the output data selection circuit 330 may connect the data bus 201 to the first signal transmission lines 211a or 211b. The data signals transmitted from either the first memory chip M11a or M11b or the second memory chip M12a or M12b through the first signal transmission lines 211a or 211b may be output through the data bus 201. When the second output selection signal R34 is enabled, the output data selection circuit 330 may connect the data bus 201 to the second signal transmission lines 212a or 212b. The data signals transmitted from either the third memory chip M13a or M13b or the fourth memory chip M14a or M14b through the second signal transmission lines 212a or 212b may be output through the data bus 201.

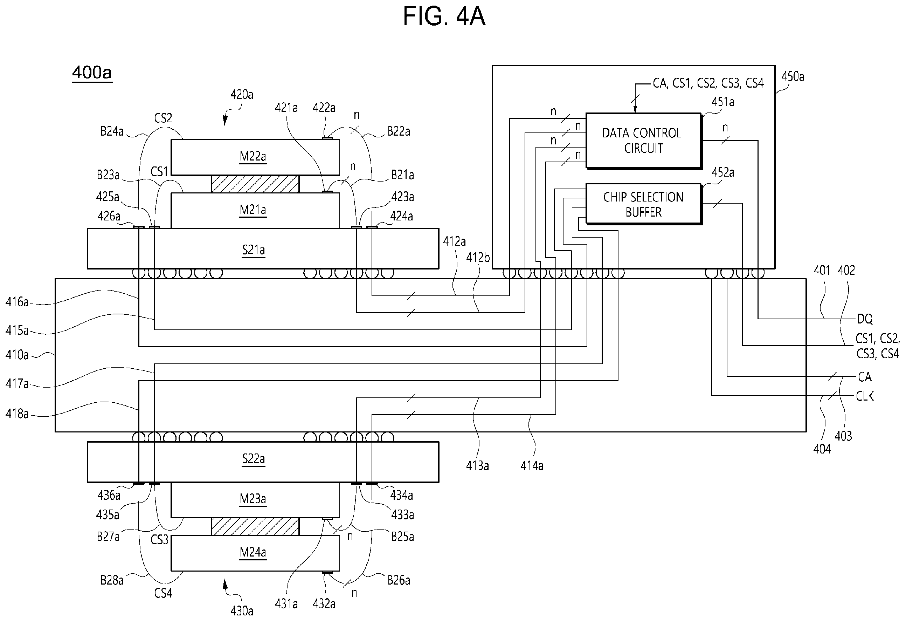

FIG. 4A is a diagram illustrating at least a part of a configuration of a memory module 400a according to an embodiment of the present disclosure. Referring to FIG. 4A, the memory module 400a may include a module substrate 410a, a first memory package 420a, a second memory package 430a, and a module controller circuit 450a. The first and second memory packages 420a and 430a may be positioned to face each other across the module substrate 410a and may correspond to, for example, the first and ninth memory packages MP1 and MP9 illustrated in FIG. 1. The module controller circuit 450a may correspond to the first module controller circuit MC1. The module substrate 410a may include first signal transmission lines 411a, second signal transmission lines 412a, third signal transmission lines 413a, and fourth signal transmission lines 414a. The module substrate 410a may further include a fifth signal transmission line 415a, a sixth signal transmission line 416a, a seventh signal transmission line 417a, and an eighth signal transmission line 418a. The first memory package 420a may be mounted on a front side (an upper side in FIG. 4A) of the module substrate 410a. The second memory package 430a may be mounted on a rear side (a lower side in FIG. 4A) of the module substrate 410a. The first and second memory packages 420a and 430a may be double-die packages (DDPs), each including two memory chips.

The first memory package 420a may include a first memory chip M21a and a second memory chip M22a. The first memory chip M21a may receive a first chip selection signal CS1 and may be accessed based on the first chip selection signal CS1. The second memory chip M22a may receive a second chip selection signal CS2 and may be accessed based on the second chip selection signal CS2. The first memory chip M21a may include data pads 421a. The second memory chip M22a may include data pads 422a.The data pads 421a of the first memory chip M21a may be coupled to the first signal transmission lines 411a. The data pads 422a of the second memory chip M22a may be coupled to the second signal transmission lines 412a. The second memory package 430a may include a third memory chip M23a and a fourth memory chip M24a. The third memory chip M23a may receive a third chip selection signal CS3 and may be accessed based on the third chip selection signal CS3. The fourth memory chip M24a may receive a fourth chip selection signal CS4 and may be accessed based on the fourth chip selection signal CS4. The third memory chip M23a may include data pads 431a. The fourth memory chip M24a may include data pads 432a. The data pads 431a of the third memory chip M23a may be coupled to the third signal transmission lines 413a. The data pads 432a of the fourth memory chip M24a may be coupled to the fourth signal transmission lines 414a.

The module controller circuit 450a may be mounted on a front side of the module substrate 410a. The module controller circuit 450a may be coupled to an external apparatus through a data bus 401. The module controller circuit 450a may be coupled to the data bus 401 through signal transmission lines formed in the module substrate 410a. The module controller circuit 450a may receive data signals DQ from the external apparatus through the data bus 401 and may output the data signals DQ to the external apparatus. The module controller circuit 450a may receive the first to fourth chip selection signals CS1-CS4. The module controller circuit 450a may connect the data bus 401 to one of the first to fourth signal transmission lines 411a to 414a based on the first to fourth chip selection signals CS1-CS4. For example, the module controller circuit 450a may connect the data bus 401 to the first signal transmission lines 411a when the first chip selection signal CS1 is asserted. The module controller circuit 450a may connect the data bus 401 to the second signal transmission lines 412a when the second chip selection signal CS2 is asserted. The module controller circuit 450a may connect the data bus 401 to the third signal transmission lines 413a when the third chip selection signal CS3 is asserted. The module controller circuit 450a may connect the data bus 401 to the fourth signal transmission lines 414a when the fourth chip selection signal CS4 is asserted. The external apparatus may access the first to fourth memory chips M21a to M24a according to the first to fourth chip selection signals CS1-CS4, but the data bus 401 might not be directly coupled to the first to fourth memory chips M21a to M24a and may be coupled to the first to fourth memory chips M21a to M24a through the module controller circuit 450a. The module controller circuit 450a may connect only one of the first to fourth signal transmission lines 411a to 414a to the data bus 401 based on the first to fourth chip selection signals CS1-CS4. Therefore, the data bus 401 may only encounter the loading of a single chip (that is, the module controller circuit), and each of the first to fourth signal transmission lines 411a to 414a may only encounter the loading of one memory chip. In the memory module 400a, because the first to fourth memory chips M21a to M24a are independently coupled to the module controller circuit 450a through different signal transmission lines, the module controller circuit 450a may further reduce the loading encountered when accessing the first and second memory packages 420a and 430a. When the module controller circuit 450a reduces the loading, the memory packages may have a structure in which the memory chips are electrically coupled using bonding wires, so the manufacturing cost of the memory packages can be reduced. The number of signal transmission lines included in the data bus 401 may be substantially the same as the number of the first to fourth signal transmission lines 411a to 414a. The data signals DQ transmitted through the data bus 401 may be entirely transmitted through one of the first to fourth signal transmission lines 411a to 414a. For example, the number of signal transmission lines included in the data bus 401 and the number of the first to fourth signal transmission lines 411a to 414a may each be n.

The module controller circuit 450a may be coupled to the fifth to eighth signal transmission lines 415a to 418a. The module controller circuit 450a may be coupled to a chip selection bus 402 through signal transmission lines formed in the module substrate 410a, and may receive the first to fourth chip selection signals CS1 to CS4 from the external apparatus through the chip selection bus 402. The module controller circuit 450a may buffer the first to fourth chip selection signals CS1 to CS4 and may transmit the buffered first to fourth chip selection signals CS1 to CS4 to the first and second memory packages 420a and 430a through the fifth to eighth signal transmission lines 415a to 418a, respectively. The module controller circuit 450a may be coupled to a command address bus 403 through signal transmission lines formed in the module substrate 410a and may receive a command address signal CA from the external apparatus through the command address bus 403. The module controller circuit 450a may be coupled to a clock bus 404 through the signal transmission lines formed in the module substrate 410a and may receive a clock signal CLK from the external apparatus through the clock bus 404 or may transmit the clock signal CLK to the external apparatus.

The first memory package 420a may include a first package substrate S21a. The first package substrate S21a may be mounted on a front side of the module substrate 410a. The first memory chip M21a may be disposed on the first package substrate S21a, and the second memory chip M22a may be disposed on the first memory chip M21a. The first memory chip M21a may be bonded to the first package substrate S21a, and the second memory chip M22a may be bonded to the first memory chip M21a by using DAF. The first package substrate S21a may include first pads 423a and second pads 424a. The first pads 423a may be coupled to the first signal transmission lines 411a. The second pads 424a may be coupled to the second signal transmission lines 412a. The first pads 423a and the second pads 424a may be coupled to the first and second signal transmission lines 411a and 412a, respectively, through package balls of the first package substrate S21a. The data pads 421a of the first memory chip M21a may be coupled to the first pads 423a, and the data pads 422a of the second memory chip M22a may be coupled to the second pads 424a. The data pads 421a of the first memory chip M21a may be connected to the first pads 423a through first bonding wires B21a. The data pads 422a of the second memory chip M22a may be connected to the second pads 424a through second bonding wires B22a. The first package substrate S21a may further include a third pad 425a and a fourth pad 426a. The third pad 425a may be coupled to the fifth signal transmission line 415a and may receive the first chip selection signal CS1 transmitted from the module controller circuit 450a through the fifth signal transmission line 415a. The fourth pad 426a may be coupled to the sixth signal transmission line 416a and may receive the second chip selection signal CS2 transmitted from the module controller circuit 450a through the sixth signal transmission line 416a. The third and fourth pads 425a and 426a may be coupled to the fifth and sixth signal transmission lines 415a and 416a, respectively, through package balls of the first package substrate S21a. The first memory chip M21a may receive the first chip selection signal CS1 through the fifth signal transmission line 415a and the third pad 425a. The first memory chip M21a may be connected to the third pad 425a through a third bonding wire B23a. The second memory chip M22a may receive the second chip selection signal CS2 through the sixth signal transmission line 416a and the fourth pad 426a. The second memory chip M22a may be connected to the fourth pad 426a through a fourth bonding wire B24a.

The second memory package 430a may include a second package substrate S22a. The second package substrate S22a may be mounted on a rear side of the module substrate 410a. The third memory chip M23a may be disposed on the second package substrate S22a, and the fourth memory chip M24a may be disposed on the third memory chip M23a. The third memory chip M23a may be bonded to the second package substrate S22a, and the fourth memory chip M24a may be bonded to the third memory chip M23a using DAF. The second package substrate S22a may include fifth pads 433a and sixth pads 434a. The fifth pads 433a may be coupled to the third signal transmission lines 413a. The sixth pads 434a may be coupled to the fourth signal transmission lines 414a. The fifth and sixth pads 433a and 434a may be respectively coupled to the third and fourth signal transmission lines 413a and 414a through package balls of the second package substrate S22a. The data pads 431a of the third memory chip M23a may be coupled to the fifth pads 433a, and the data pads 432a of the fourth memory chip M24a may be coupled to the sixth pads 434a. The data pads 431a of the third memory chip M23a may be connected to the fifth pads 433a through fifth bonding wires B25a. The data pads 432a of the fourth memory chip M24a may be connected to the sixth pads 434a through sixth bonding wires B26a. The second package substrate S22a may further include a seventh pad 435a and an eighth pad 436a. The seventh pad 435a may be coupled to the seventh signal transmission line 417a and may receive the third chip selection signal CS3 transmitted from the module controller circuit 450a through the seventh signal transmission line 417a. The eighth pad 436a may be coupled to the eighth signal transmission line 418a and may receive the fourth chip selection signal CS4 transmitted from the module controller circuit 450a through the eighth signal transmission line 418a. The seventh and eighth pads 435a and 436a may be respectively coupled to the seventh and eighth signal transmission lines 417a and 418a through package balls of the second package substrate S22a. The third memory chip M23a may receive the third chip selection signal CS3 through the seventh signal transmission line 417a and the seventh pad 435a. The third memory chip M23a may be connected to the seventh pad 435a through a seventh bonding wire B27a. The fourth memory chip M24a may receive the fourth chip selection signal CS4 through the eighth signal transmission line 418a and the eighth pad 436a. The fourth memory chip M24a may be connected to the eighth pad 436a through an eighth bonding wire B28a.

The module controller circuit 450a may include a data control circuit 451a and a chip selection buffer 452a. The module controller circuit 450a may receive the first to fourth chip selection signals CS1 to CS4 and may connect the data bus 401 to one of the first to fourth signal transmission lines 411a to 414a based on the first to fourth chip selection signals CS1 to CS4. The data control circuit 451a may connect the data bus 401 to the first signal transmission lines 411a when the first chip selection signal CS1 is asserted, thereby forming a data path between the first memory chip M21a and the data bus 401. The data control circuit 451a may connect the data bus 401 to the second signal transmission lines 412a when the second chip selection signal CS2 is asserted, thereby forming a data path between the second memory chip M22a and the data bus 401. The data control circuit 451a may connect the data bus 401 to the third signal transmission lines 413a when the third chip selection signal CS3 is asserted, thereby forming a data path between the third memory chip M23a and the data bus 401. The data control circuit 451a may connect the data bus 401 to the fourth signal transmission line 414a when the fourth chip selection signal CS4 is asserted, thereby forming a data path between the fourth memory chip M24a and the data bus 401. The data control circuit 451a may further receive the command address signal CA. The data control circuit 451a may form a data path from the data bus 401 to one of the first to fourth signal transmission lines 411a to 414a or form a data path from one of the first to fourth signal transmission lines 411a and 414a to the data bus 401, based on the command address signal CA. The chip selection buffer 452a may receive the first to fourth chip selection signals CS1 to CS4 through the chip selection bus 402. The chip selection buffer 452a may buffer the first to fourth chip selection signals CS1 to CS4 and may respectively transmit the buffered first to fourth chip selection signals CS1 to CS4 to the first to fourth memory chips M21a to M24a. The chip selection buffer 452a may output the first chip selection signal CS1 to the fifth signal transmission line 415a, may output the second chip selection signal CS2 to the sixth signal transmission line 416a, may output the third chip selection signal CS3 to the seventh signal transmission line 417a, and may output the fourth chip selection signal CS4 to the eighth signal transmission line 418a.

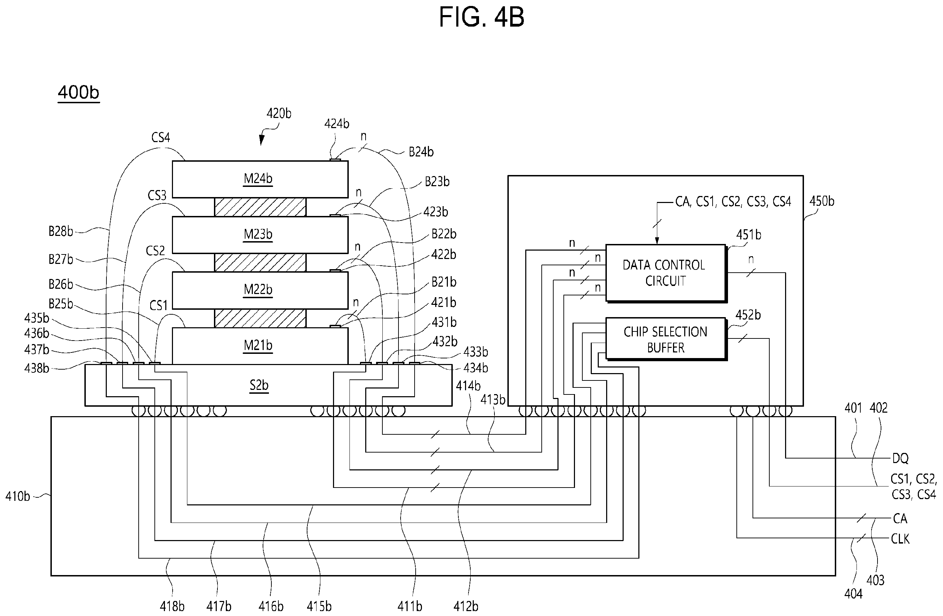

FIG. 4B is a diagram illustrating at least a part of a configuration of a memory module 400b according to an embodiment of the present disclosure. Referring to FIG. 4B, the memory module 400b may include a module substrate 410b, a memory package 420b, and a module controller circuit 450b. The memory package 420b may correspond to one of the first and ninth memory packages MP1 and MP9 illustrated in FIG. 1, and the module controller circuit 450b may correspond to the first module controller circuit MC1. The module substrate 410b may include first signal transmission lines 411b, second signal transmission lines 412b, third signal transmission lines 413b, and fourth signal transmission lines 414b. The module substrate 410b may further include a fifth signal transmission line 415b, a sixth signal transmission line 416b, a seventh signal transmission line 417b, and an eighth signal transmission line 418b. The memory package 420b may be mounted on the module substrate 410b. The memory package 420b may be a QDP (Quad-Die Package) including four memory chips.

The memory package 420b may include a first memory chip M21b, a second memory chip M22b, a third memory chip M23b, and a fourth memory chip M24b. The first memory chip M21b may receive a first chip selection signal CS1 and may be accessed based on the first chip selection signal CS1. The second memory chip M22b may receive a second chip selection signal CS2 and may be accessed based on the second chip selection signal CS2. The third memory chip M23b may receive a third chip selection signal CS3 and may be accessed based on the third chip selection signal CS3. The fourth memory chip M24b may receive a fourth chip selection signal CS4 and may be accessed based on the fourth chip selection signal CS4. The first to fourth memory chips M21b to M24b may respectively include data pads 421b, 422b, 423b, and 424b. The data pads 421b of the first memory chip M21b may be coupled to the first signal transmission lines 411b. The data pads 422b of the second memory chip M22b may be coupled to the second signal transmission lines 412b. The data pads 423b of the third memory chip M23b may be coupled to the third signal transmission lines 413b. The data pads 424b of the fourth memory chip M24b may be coupled to the fourth signal transmission lines 414b.

The module controller circuit 450b may be mounted on the module substrate 410b. The module controller circuit 450b may be coupled to an external apparatus through a data bus 401. The module controller circuit 450b may be coupled to the data bus 401 through signal transmission lines formed in the module substrate 410b. The module controller circuit 450b may receive data signals DQ from the external apparatus through the data bus 401 and may output the data signals DQ to the external apparatus. The module controller circuit 450b may receive the first to fourth chip selection signals CS1 to CS4. The module controller circuit 450b may connect the data bus 401 to one of the first to fourth signal transmission lines 411b to 414b based on the first to fourth chip selection signals CS1 to CS4. For example, when the first chip selection signal CS1 is asserted, the module controller circuit 450b may connect the data bus 401 to the first signal transmission lines 411b. When the second chip selection signal CS2 is asserted, the module controller circuit 450b may connect the data bus 401 to the second signal transmission lines 412b. When the third chip selection signal CS3 is asserted, the module controller circuit 450b may connect the data bus 401 to the third signal transmission lines 413b. When the fourth chip selection signal CS4 is asserted, the module controller circuit 450b may connect the data bus 401 to the fourth signal transmission lines 414b. The external apparatus may access the first to fourth memory chips M21b to M24b according to the first to fourth chip selection signals CS1 to CS4, but the data bus 401 might not be directly coupled to the first to fourth memory chips M21b to M24b and instead may be coupled to the first to fourth memory chips M21b to M24b through the module controller circuit 450b. The module controller circuit 450b may connect only one of the first to fourth signal transmission lines 411b to 414b to the data bus 401 based on the first to fourth chip selection signals CS1 to CS4. Therefore, the data bus 401 may encounter only a single chip loading (that is, the module controller circuit), and the first to fourth signal transmission lines 411b to 414b may also each encounter the loading corresponding to only one memory chip. The number of signal transmission lines included in the data bus 401 may be substantially the same as the number of the first to fourth signal transmission lines 411b to 414b. Data signals DQ transmitted through the data bus 401 may all be transmitted through one of the first to fourth signal transmission lines 411b to 414b. For example, the number of signal transmission lines included in the data bus 401 and the number of the first to fourth signal transmission lines 411b to 414b may each be n.

The module controller circuit 450b may be coupled to the fifth to eighth signal transmission lines 415b to 418b. The module controller circuit 450b is coupled to a chip selection bus 402 through signal transmission lines formed in the module substrate 410b and may receive the first to fourth chip selection signals CS1 to CS4 from the external apparatus through the chip selection bus 402. The module controller circuit 450b buffers the first to fourth chip selection signals CS1 to CS4 and may transmit the buffered first to fourth chip selection signals CS1 to CS4 to the memory package 420b through the fifth to eighth signal transmission lines 415b to 418b. The module controller circuit 450b is coupled to a command address bus 403 through signal transmission lines formed in the module substrate 410b and may receive a command address signal CA from the external apparatus through the command address bus 403. The module controller circuit 450b is coupled to a clock bus 404 through signal transmission lines formed in the module substrate 410b and may receive a clock signal CLK from the external apparatus or transmit the clock signal CLK to the external apparatus through the clock bus 404.

The memory package 420b may include a package substrate S2b. The package substrate S2b may be mounted on the module substrate 410b. The first memory chip M21b may be disposed on the package substrate S2b, the second memory chip M22b may be disposed on the first memory chip M21b, the third memory chip M23b may be disposed on the second memory chip M22b, and the fourth memory chip M24b may be disposed on the third memory chip M23b. The first memory chip M21b may be bonded to the package substrate S2b, and the second to fourth memory chips M22b to M24b may be bonded to the first to third memory chips M21b to M23b, respectively, using DAF. The package substrate S2b may include first pads 431b, second pads 432b, third pads 433b, and fourth pads 434b. The first pads 431b may be coupled to the first signal transmission lines 411b, the second pads 432b may be coupled to the second signal transmission lines 412b, the third pads 433b may be coupled to the third signal transmission lines 413b, and the fourth pads 434b may be coupled to the fourth signal transmission lines 414b. The first to fourth pads 431b to 434b may be coupled to the first to fourth signal transmission lines 411b to 414b, respectively, through package balls of the package substrate S2b. The data pads 421b of the first memory chip M21b may be coupled to the first pads 431b, the data pads 422b of the second memory chip M22b may be coupled to the second pads 432b, the data pads 423b of the third memory chip M23b may be coupled to the third pads 433b, and the data pads 424b of the fourth memory chip M24b may be coupled to the fourth pads 434b. The data pads 421b of the first memory chip M21b may be connected to the first pads 431b through first bonding wires B21b, the data pads 422b of the second memory chip M22b may be connected to the second pads 432b through second bonding wires B22b, the data pads 423b of the third memory chip M23b may be connected to the third pads 433b through third bonding wires B23b, and the data pads 424b of the fourth memory chip M24b may be connected to the fourth pads 434b through fourth bonding wires B24b. The package substrate S2b may further include a fifth pad 435b, a sixth pad 436b, a seventh pad 437b, and an eighth pad 438b. The fifth pad 435b may be coupled to the fifth signal transmission line 415b and may receive the first chip selection signal CS1 transmitted from the module controller circuit 450b through the fifth signal transmission line 415b. The sixth pad 436b may be coupled to the sixth signal transmission line 416b and may receive the second chip selection signal CS2 transmitted from the module controller circuit 450b through the sixth signal transmission line 416b. The seventh pad 437b may be coupled to the seventh signal transmission line 417b and may receive the third chip selection signal CS3 transmitted from the module controller circuit 450b through the seventh signal transmission line 417b. The eighth pad 438b may be coupled to the eighth signal transmission line 418b and may receive the fourth chip selection signal CS4 transmitted from the module controller circuit 450b through the eighth signal transmission line 418b. The fifth to eighth pads 435b to 438b may be coupled to the fifth to eighth signal transmission lines 415b to 418b, respectively, through package balls of the package substrate S2b. The first memory chip M21b may receive the first chip selection signal CS1 through the fifth signal transmission line 415b and the fifth pad 435b and may be connected to the fifth pad 435b through a fifth bonding wire B25b. The second memory chip M22b may receive the second chip selection signal CS2 through the sixth signal transmission line 416b and the sixth pad 436b and may be connected to the sixth pad 436b through a sixth bonding wire B26b. The third memory chip M23b may receive the third chip selection signal CS3 through the seventh signal transmission line 417b and the seventh pad 437b and may be connected to the seventh pad 437b through a seventh bonding wire B27b. The fourth memory chip M24b may receive the fourth chip selection signal CS4 through the eighth signal transmission line 418b and the eighth pad 438b and may be connected to the eighth pad 438b through an eighth bonding wire B28b.

The module controller circuit 450b may include a data control circuit 451b and a chip selection buffer 452b. The module controller circuit 450b may receive the first to fourth chip selection signals CS1 to CS4 and, based on the first to fourth chip selection signals CS1 to CS4, may connect the data bus 401 to one of the first to fourth signal transmission lines 411b to 414b. The data control circuit 451b may connect the data bus 401 to the first signal transmission lines 411b when the first chip selection signal CS1 is asserted, thereby forming a data path between the first memory chip M21b and the data bus 401. The data control circuit 451b may connect the data bus 401 to the second signal transmission lines 412b when the second chip selection signal CS2 is asserted, thereby forming a data path between the second memory chip M22b and the data bus 401. The data control circuit 451b may connect the data bus 401 to the third signal transmission lines 413b when the third chip selection signal CS3 is asserted, thereby forming a data path between the third memory chip M23b and the data bus 401. The data control circuit 451b may connect the data bus 401 to the fourth signal transmission lines 414b when the fourth chip selection signal CS4 is asserted, thereby forming a data path between the fourth memory chip M24b and the data bus 401. The data control circuit 451b may further receive the command address signal CA. The data control circuit 451b may form a data path from the data bus 401 to one of the first to fourth signal transmission lines 411b to 414b or form a data path from one of the first to fourth signal transmission lines 411b and 414b to the data bus 401, based on the command address signal CA. The chip selection buffer 452b may receive the first to fourth chip selection signals CS1 to CS4 through the chip selection bus 402. The chip selection buffer 452b may buffer the first to fourth chip selection signals CS1 to CS4 and may transmit the buffered first to fourth chip selection signals CS1 to CS4 to the first to fourth memory chips M21b to M24b, respectively. The chip selection buffer 452b may output the first chip selection signal CS1 to the fifth signal transmission line 415b, the second chip selection signal CS2 to the sixth signal transmission line 416b, the third chip selection signal CS3 to the seventh signal transmission line 417b, and the fourth chip selection signal CS4 to the eighth signal transmission line 418b.

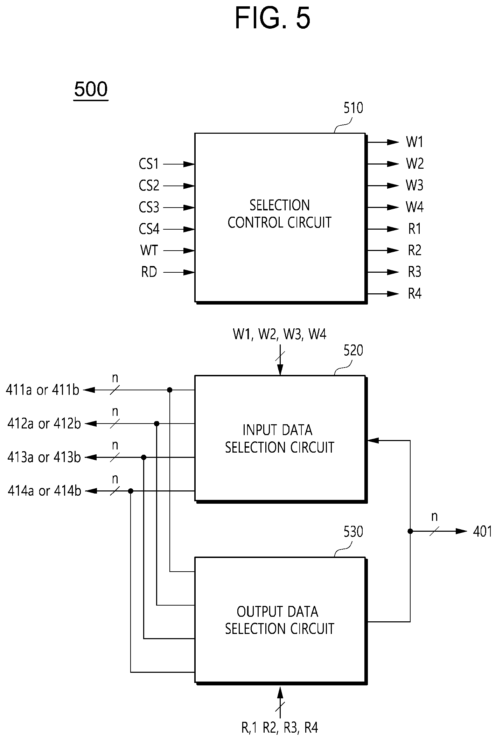

FIG. 5 is a diagram illustrating a configuration of a data control circuit 500 according to an embodiment of the present disclosure. The data control circuits 451a and 451b illustrated in FIGS. 4A and 4B may be implemented as the data control circuit 500. Referring to FIG. 5, the data control circuit 500 may include a selection control circuit 510, an input data selection circuit 520, and an output data selection circuit 530. The selection control circuit 510 may receive the first to fourth chip selection signals CS1 to CS4, a write signal WT, and a read signal RD. The selection control circuit 510 may generate a first input selection signal W1, a second input selection signal W2, a third input selection signal W3, a fourth input selection signal W4, a first output selection signal R1, a second output selection signal R2, a third output selection signal R3, and a fourth output selection signal R4 based on the first to fourth chip selection signals CS1 to CS4, the write signal WT, and the read signal RD. The selection control circuit 510 may enable the first input selection signal W1 when the write signal WT is asserted and the first chip selection signal CS1 is asserted. The selection control circuit 510 may enable the second input selection signal W2 when the write signal WT is asserted and the second chip selection signal CS2 is asserted. The selection control circuit 510 may enable the third input selection signal W3 when the write signal WT is asserted and the third chip selection signal CS3 is asserted. The selection control circuit 510 may enable the fourth input selection signal W4 when the write signal WT is asserted and the fourth chip selection signal CS4 is asserted. The selection control circuit 510 may enable the first output selection signal R1 when the read signal RD is asserted and the first chip selection signal CS1 is asserted. The selection control circuit 510 may enable the second output selection signal R2 when the read signal RD is asserted and the second chip selection signal CS2 is asserted. The selection control circuit 510 may enable the third output selection signal R3 when the read signal RD is asserted and the third chip selection signal CS3 is asserted. The selection control circuit 510 may enable the fourth output selection signal R4 when the read signal RD is asserted and the fourth chip selection signal CS4 is asserted.

The input data selection circuit 520 may be coupled between the data bus 401 and each of the first signal transmission lines 411a or 411b, the second signal transmission lines 412a or 412b, the third signal transmission lines 413a or 413b, and the fourth signal transmission lines 414a or 414b. The input data selection circuit 520 may receive the first to fourth input selection signals W1 to W4. The input data selection circuit 520 may connect the data bus 401 to one of the first signal transmission lines 411a or 411b, the second signal transmission lines 412a or 412b, the third signal transmission lines 413a or 413b, and the fourth signal transmission lines 414a or 414b based on the first to fourth input selection signals W1 to W4. When the first input selection signal W1 is enabled, the input data selection circuit 520 may connect the data bus 401 to the first signal transmission lines 411a or 411b. The data signals received through the data bus 401 may be transmitted to the first memory chip M21a or M21b through the first signal transmission lines 411a or 411b. When the second input selection signal W2 is enabled, the input data selection circuit 520 may connect the data bus 401 to the second signal transmission lines 412a or 412b. The data signals received through the data bus 401 may be transmitted to the second memory chip M22a or M22b through the second signal transmission lines 412a or 412b. When the third input selection signal W3 is enabled, the input data selection circuit 520 may connect the data bus 401 to the third signal transmission lines 413a or 413b. The data signals received through the data bus 401 may be transmitted to the third memory chip M23a or M23b through the third signal transmission lines 413a or 413b. When the fourth input selection signal W4 is enabled, the input data selection circuit 520 may connect the data bus 401 to the fourth signal transmission lines 414a or 414b. The data signals received through the data bus 401 may be transmitted to the fourth memory chip M24a or M24b through the fourth signal transmission lines 414a or 414b.

The output data selection circuit 530 may be coupled between the data bus 401 and each of the first signal transmission lines 411a or 411b, the second signal transmission lines 412a or 412b, the third signal transmission lines 413a or 413b, and the fourth signal transmission lines 414a or 414b. The output data selection circuit 530 may receive the first to fourth output selection signals R1 to R4. The output data selection circuit 530 may connect the data bus 401 to one of the first signal transmission lines 411a or 411b, the second signal transmission lines 412a or 412b, the third signal transmission lines 413a or 413b, and the fourth signal transmission lines 414a or 414b based on the first to fourth output selection signals R1 to R4. When the first output selection signal R1 is enabled, the output data selection circuit 530 may connect the data bus 401 to the first signal transmission lines 411a or 411b. The data signals transmitted from the first memory chip M21a or M21b through the first signal transmission lines 411a or 411b may be output through the data bus 401. When the second output selection signal R2 is enabled, the output data selection circuit 530 may connect the data bus 401 to the second signal transmission lines 412a or 412b. The data signals transmitted from the second memory chip M22a or M22b through the second signal transmission lines 412a or 412b may be output through the data bus 401. When the third output selection signal R3 is enabled, the output data selection circuit 530 may connect the data bus 401 to the third signal transmission lines 413a or 413b. The data signals transmitted from the third memory chip M23a or M23b through the third signal transmission lines 413a or 413b may be output through the data bus 401. When the fourth output selection signal R4 is enabled, the output data selection circuit 530 may connect the data bus 401 to the fourth signal transmission lines 414a or 414b. The data signals transmitted from the fourth memory chip M24a or M24b through the fourth signal transmission lines 414a or 414b may be output through the data bus 401.

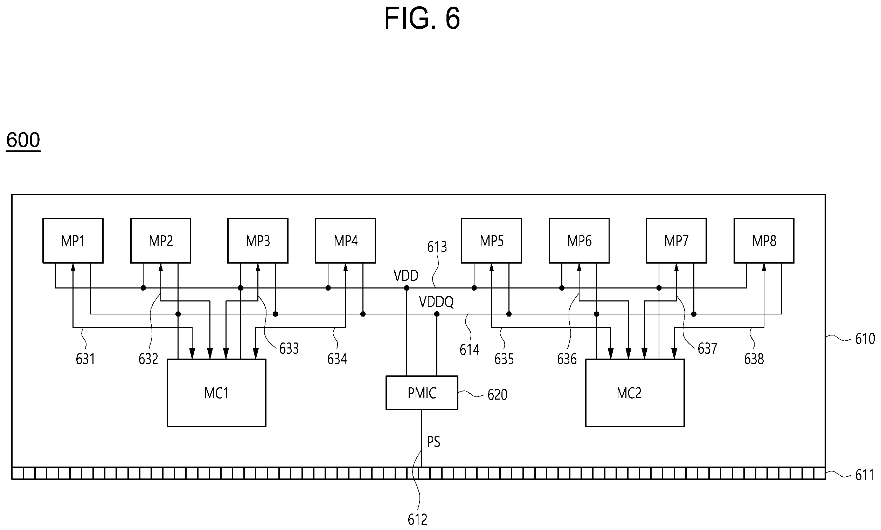

FIG. 6 is a diagram illustrating a configuration of a memory module 600 according to an embodiment of the present disclosure. Referring to FIG. 6, the memory module 600 may include a module substrate 610, a first module controller circuit MC1, a second module controller circuit MC2, a first memory package MP1, a second memory package MP2, a third memory package MP3, a fourth memory package MP4, a fifth memory package MP5, a sixth memory package MP6, a seventh memory package MP7, an eighth memory package MP8, and a PMIC, the power management integrated circuit 620. The first and second module controller circuits MC1 and MC2, the first to eighth memory packages MP1 to MP8, and the power management integrated circuit 620 may be mounted on the module substrate 610. The module substrate 610 may include module pins 611, a first power line 612, a second power line 613, and a third power line 614. The module substrate 610 may be coupled to a power supply external to the memory module 600 through the first power line 612 and the module pins 611 and may receive power PS from the power supply. The power management integrated circuit 620 may generate various power voltages based on the power PS. The power management integrated circuit 620 may comprise a voltage generation circuit, a voltage regulator, and the like to generate various power voltages from the power PS. The power management integrated circuit 620 may generate at least a first power voltage VDD and a second power voltage VDDQ from the power PS. The second power voltage VDDQ may have a lower voltage level than the first power voltage VDD. The power management integrated circuit 620 may supply the first power voltage VDD through the second power line 613 and may supply the second power voltage VDDQ through the third power line 614.

The first and second module controller circuits MC1 and MC2 and the first to eighth memory packages MP1 to MP8 may be coupled to the second and third power lines 613 and 614. The first and second module controller circuits MC1 and MC2 and the first to eighth memory packages MP1 to MP8 may respectively be coupled to the second power line 613 to receive the first power voltage VDD supplied from the power management integrated circuit 620. The first and second module controller circuits MC1 and MC2 and the first to eighth memory packages MP1 to MP8 may respectively be coupled to the third power line 614 to receive the second power voltage VDDQ supplied from the power management integrated circuit 620, (PMIC). The first and second module controller circuits MC1 and MC2 and the first to eighth memory packages MP1 to MP8 may operate based on the first and second power voltages VDD and VDDQ, respectively. For example, some of the internal circuits of the first and second module controller circuits MC1 and MC2 and some of the internal circuits of the first to eighth memory packages MP1 to MP8 may operate based on the first power voltage VDD. Internal circuits performing data input/output operations in the first and second module controller circuits MC1 and MC2 and in the first to eighth memory packages MP1 to MP8 may respectively operate based on the second power voltage VDDQ. As illustrated in FIGS. 4A and 4B, when the module controller circuits 450a and 450b are coupled to each memory chip through different signal transmission lines, the loading of the signal transmission lines may be minimized. Therefore, the swing range of data signals transmitted through the signal transmission lines may be reduced, and the reduction in the swing range of the data signals may effectively reduce the power consumption of the memory module.

The module substrate 610 may include a first signal transmission line group 631, a second signal transmission line group 632, a third signal transmission line group 633, a fourth signal transmission line group 634, a fifth signal transmission line group 635, a sixth signal transmission line group 636, a seventh signal transmission line group 637, and an eighth signal transmission line group 638. The first to fourth signal transmission line groups 631 to 634 may respectively connect the first module controller circuit MC1 and the first to fourth memory packages MP1 to MP4. The first to fourth signal transmission line groups 631 to 634 may be sets of signal transmission lines that respectively connect the first module controller circuit MC1 and memory chips included in the first to fourth memory packages MP1 to MP4. The fifth to eighth signal transmission line groups 635 to 638 may respectively connect the second module controller circuit MC2 and the fifth to eighth memory packages MP5 to MP8. The fifth to eighth signal transmission line groups 635 to 638 may be sets of signal transmission lines that respectively connect the second module controller circuit MC2 and memory chips included in the fifth to eighth memory packages MP5 to MP8. The first module controller circuit MC1 and the first to fourth memory packages MP1 to MP4 may drive the first to fourth signal transmission line groups 631 to 634 with the second power voltage VDDQ. The second module controller circuit MC2 and the fifth to eighth memory packages MP5 to MP8 may drive the fifth to eighth signal transmission line groups 635 to 638 with the second power voltage VDDQ. Signals transmitted through the first to eighth signal transmission line groups 631 to 638 may swing within a range between the second power voltage VDDQ and a ground voltage. Signals transmitted within the first and second module controller circuits MC1 and MC2 and within the first to eighth memory packages MP1 to MP8 may swing within a range between the first power voltage VDD and the ground voltage.

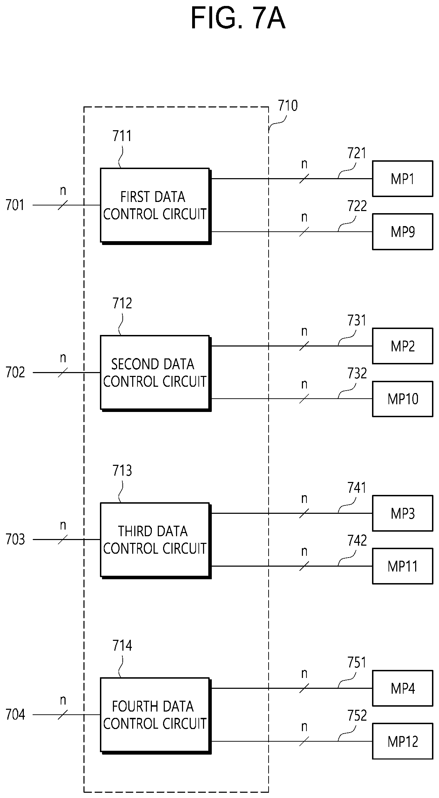

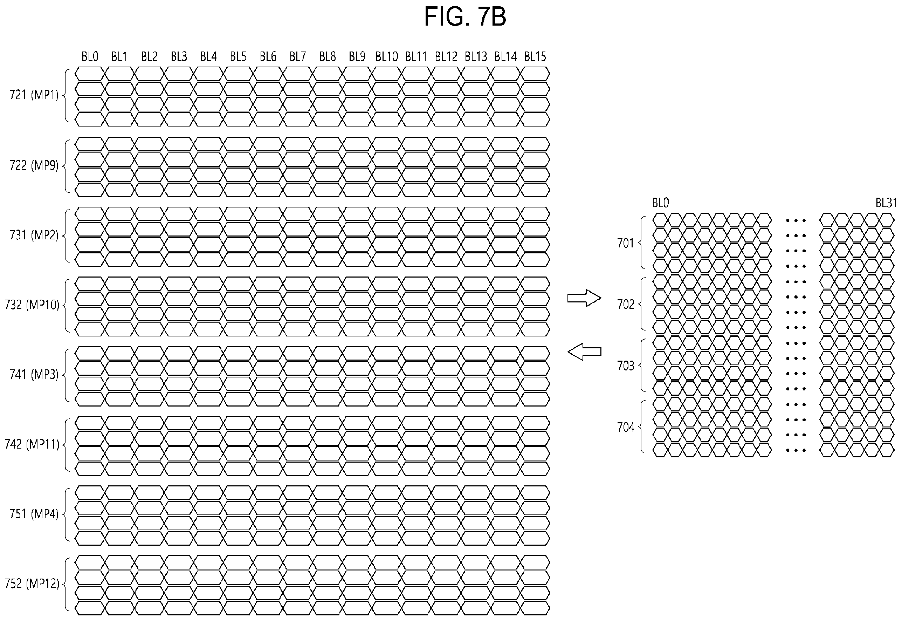

FIG. 7A is a diagram illustrating a configuration of a memory module 700 according to an embodiment of the present disclosure, and FIG. 7B is a timing diagram illustrating an operation of the memory module 700 according to an embodiment of the present disclosure. Referring to FIG. 7A, the memory module 700 may perform a function of an MRDIMM ( Multiplexer Rank Dual Inline Memory Module).A **rank** is a subset of memory chips on a memory module. The MRDIMM may simultaneously operate multiple ranks to increase an effective bandwidth between the memory module and an external apparatus. The memory module 700 may include a module controller circuit 710 and a plurality of memory packages. The memory module 700 may include a first to fourth memory packages MP1 to MP4 and a ninth to twelfth memory packages MP9 to MP12. For example, as illustrated in FIG. 1, the first to fourth memory packages MP1 to MP4 may be mounted on a front side of the memory module 700, and the ninth to twelfth memory packages MP9 to MP12 may be mounted on a rear side of the memory module 700. The module controller circuit 710 may be coupled to the external apparatus through a plurality of data buses, 701-704 and may be respectively coupled to the first to fourth memory packages MP1 to MP4 and the ninth to twelfth memory packages MP9 to MP12 through a plurality of signal transmission lines. The module controller circuit 710 may include a plurality of data control circuits. The plurality of data control circuits may be coupled between one data bus and two memory packages.

A first data control circuit 711 may be coupled to the external apparatus through a first data bus 701 and may be coupled to the first and ninth memory packages MP1 and MP9 through first and second signal transmission lines 721 and 722. The first data bus 701 may include n signal transmission lines, and the first and second signal transmission lines 721 and 722 may each have n lines. A second data control circuit 712 may be coupled to the external apparatus through a second data bus 702 and may be coupled to the second and tenth memory packages MP2 and MP10 through third and fourth signal transmission lines 731 and 732. The second data bus 702 may include n signal transmission lines, and the third and fourth signal transmission lines 731 and 732 may each have n lines. A third data control circuit 713 may be coupled to the external apparatus through a third data bus 703 and may be coupled to the third and eleventh memory packages MP3 and MP11 through fifth and sixth signal transmission lines 741 and 742. The third data bus 703 may include n signal transmission lines, and the fifth and sixth signal transmission lines 741 and 742 may each have n lines. A fourth data control circuit 714 may be coupled to the external apparatus through a fourth data bus 704 and may be coupled to the fourth and twelfth memory packages MP4 and MP12 through seventh and eighth signal transmission lines 751 and 752. The fourth data bus 704 may include n signal transmission lines, and the seventh and eighth signal transmission lines 751 and 752 may each have n lines. The first data control circuit 711 may divide data signals received through the first data bus 701 and may transmit the divided data signals to the first and ninth memory packages MP1 and MP9 through the first and second signal transmission lines 721 and 722. The first data control circuit 711 may merge data signals received from the first and ninth memory packages MP1 and MP9 through the first and second signal transmission lines 721 and 722 and may transmit the merged data signals to the external apparatus through the first data bus 701. The second data control circuit 712 may divide data signals received through the second data bus 702 and may transmit the divided data signals to the second and tenth memory packages MP2 and MP10 through the third and fourth signal transmission lines 731 and 732. The second data control circuit 712 may merge data signals received from the second and tenth memory packages MP2 and MP10 through the third and fourth signal transmission lines 731 and 732 and may transmit the merged data signals to the external apparatus through the second data bus 702. The third data control circuit 713 may divide data signals received through the third data bus 703 and may transmit the divided data signals to the third and eleventh memory packages MP3 and MP11 through the fifth and sixth signal transmission lines 741 and 742. The third data control circuit 713 may merge data signals received from the third and eleventh memory packages MP3 and MP11 through the fifth and sixth signal transmission lines 741 and 742 and may transmit the merged data signals to the external apparatus through the third data bus 703. The fourth data control circuit 714 may divide data signals received through the fourth data bus 704 and may transmit the divided data signals to the fourth and twelfth memory packages MP4 and MP12 through the seventh and eighth signal transmission lines 751 and 752. The fourth data control circuit 714 may merge data signals received from the fourth and twelfth memory packages MP4 and MP12 through the seventh and eighth signal transmission lines 751 and 752 and may transmit the merged data signals to the external apparatus through the fourth data bus 704.

Referring also to FIG. 7B, data signals of BL0 to BL31 may be transmitted through the first data bus 701, the second data bus 702, the third data bus 703, and the fourth data bus 704, respectively. Here, BL may be a burst length. For example, when each data bus includes four signal transmission lines, 128-bit data signals may be transmitted at a time through each of the first to fourth data buses 701 to 704. Data signals of BL0 to BL15 may be transmitted through each of the first signal transmission lines 721, the second signal transmission lines 722, the third signal transmission lines 731, the fourth signal transmission lines 732, the fifth signal transmission lines 741, the sixth signal transmission lines 742, the seventh signal transmission lines 751, and the eighth signal transmission lines 752. Here a signal transmission line is defined as one line supporting 16 data bits. In some embodiments of CS signals, the signal transmission line has a one bit width for each CS signal. When each of the signal transmission lines includes four lines, 64 data signals may be transmitted through each of the first to eighth signal transmission lines 721, 722, 731, 732, 741, 742, 751, and 752. The first data control circuit 711 may transmit first to 64th bits of the 128-bit data signals on the first data bus 701 to the first memory package MP1 through the first signal transmission lines 721, and may transmit 65th to 128th bits of the data signals to the ninth memory package MP9 through the second signal transmission lines 722. The first data control circuit 711 may transmit the 64-bit data signals received from the first memory package MP1 through the first signal transmission lines 721 and the 64-bit data signals received from the ninth memory package MP9 through the second signal transmission lines 722 to the external apparatus through the first data bus 701. The second data control circuit 712 may transmit first to 64th bits of the 128-bit data signals on the second data bus 702 to the second memory package MP2 through the third signal transmission lines 731, and may transmit 65th to 128th bits of the data signals to the tenth memory package MP10 through the fourth signal transmission lines 732. The second data control circuit 712 may transmit the 64-bit data signals received from the second memory package MP2 through the third signal transmission lines 731 and the 64-bit data signals received from the tenth memory package MP10 through the fourth signal transmission lines 732 to the external apparatus through the second data bus 702. The third data control circuit 713 may transmit first to 64th bits of the 128-bit data signals on the third data bus 703 to the third memory package MP3 through the fifth signal transmission lines 741, and may transmit 65th to 128th bits of the data signals to the eleventh memory package MP11 through the sixth signal transmission lines 742. The third data control circuit 713 may transmit the 64-bit data signals received from the third memory package MP3 through the fifth signal transmission lines 741 and the 64-bit data signals received from the eleventh memory package MP11 through the sixth signal transmission lines 742 to the external apparatus through the third data bus 703. The fourth data control circuit 714 may transmit first to 64th bits of the 128-bit data signals on the fourth data bus 704 to the fourth memory package MP4 through the seventh signal transmission lines 751, and may transmit 65th to 128th bits of the data signals to the twelfth memory package MP12 through the eighth signal transmission lines 752. The fourth data control circuit 714 may transmit the 64-bit data signals received from the fourth memory package MP4 through the seventh signal transmission lines 751 and the 64-bit data signals received from the twelfth memory package MP12 through the eighth signal transmission lines 752 to the external apparatus through the fourth data bus 704. The number of data signals transmitted between the external apparatus and the data control circuits may be twice the number of data signals transmitted between the data control circuits and the memory packages. Accordingly, the duration of the data signals transmitted between the data control circuits and the memory packages may be twice the duration of the data signals transmitted between the data control circuits and the external apparatus. Because the module controller circuit 710 may perform data input/output operations at a conventional operating speed with the memory packages, while the operating speed between the memory module 700 and the external apparatus may be doubled, the memory module 700 may perform an MRDIMM function and may increase the bandwidth of a computing system.

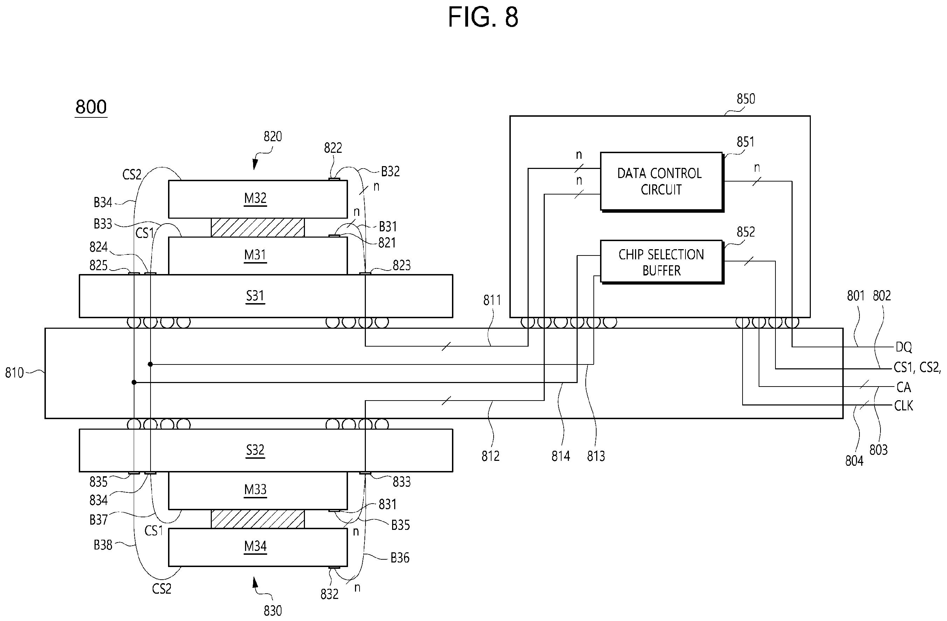

FIG. 8 is a diagram illustrating at least a part of a configuration of a memory module 800 according to an embodiment of the present disclosure. Referring to FIG. 8, the memory module 800 may include a module substrate 810, a first memory package 820, a second memory package 830, and a module controller circuit 850. The first and second memory packages 820 and 830 may face each other across the module substrate 810 and may correspond to memory packages MP1 and MP9 illustrated in FIG. 1, respectively. The module controller circuit 850 may correspond to the first module controller circuit MC1. The module substrate 810 may include first signal transmission lines 811 and second signal transmission lines 812. The module substrate 810 may further include a third signal transmission line 813 and a fourth signal transmission line 814. The first memory package 820 may be mounted on a front side (i.e., an upper side in FIG. 8) of the module substrate 810. The second memory package 830 may be mounted on a rear side (i.e., a lower side in FIG. 8) of the module substrate 810. The first and second memory packages 820 and 830 may be double-die packages (DDPs), each including two memory chips.

The first memory package 820 may include a first memory chip M31 and a second memory chip M32. The first memory chip M31 may receive a first chip selection signal CS1 and may be accessed based on the first chip selection signal CS1. The second memory chip M32 may receive a second chip selection signal CS2 and may be accessed based on the second chip selection signal CS2. The first and second memory chips M31 and M32 may include data pads 821 and 822, respectively. Data pads 821 of the first memory chip M31 and data pads 822 of the second memory chip M32 may be coupled in common to the first signal transmission lines 811. The second memory package 830 may include a third memory chip M33 and a fourth memory chip M34. The third memory chip M33 may receive the first chip selection signal CS1 and may be accessed based on the first chip selection signal CS1. The fourth memory chip M34 may receive the second chip selection signal CS2 and may be accessed based on the second chip selection signal CS2. The third and fourth memory chips M33 and M34 may include data pads 831 and 832, respectively. Data pads 831 of the third memory chip M33 and data pads 832 of the fourth memory chip M34 may be coupled in common to the second signal transmission lines 812.

The module controller circuit 850 may be mounted on a front side of the module substrate 810. The module controller circuit 850 may be coupled to an external apparatus through a data bus 801. The module controller circuit 850 may be coupled to the data bus 801 through signal transmission lines formed in the module substrate 810. The module controller circuit 850 may receive data signals DQ from the external apparatus through the data bus 801 and may output the data signals DQ to the external apparatus. The module controller circuit 850 may connect the data bus 801 in common to the first and second signal transmission lines 811 and 812. The module controller circuit 850 may divide the data signals received through the data bus 801 and may output the divided data signals to the first and second signal transmission lines 811 and 812, respectively. The module controller circuit 850 may merge data signals received through the first and second signal transmission lines 811 and 812 and may output the merged data signals to the data bus 801. The data bus 801 may encounter a single chip loading (i.e., the module controller circuit), and the first and second signal transmission lines 811 and 812 may each encounter only the loading corresponding to two memory chips. The module controller circuit 850 may double the bandwidth between the external apparatus and the memory module 800 while maintaining the bandwidth of the memory chips M31 to M34. The number of signal transmission lines included in the data bus 801 may be substantially equal to the number of the first and second signal transmission lines 811 and 812, respectively. For example, the number of signal transmission lines included in the data bus 801 and the number of the first and second signal transmission lines 811 and 812 may each be n. The duration of data signals transmitted through the first and second signal transmission lines 811 and 812 may be twice the duration of data signals DQ transmitted through the data bus 801. Therefore, when 2n data signals DQ are transmitted through the data bus 801, n data signals may be transmitted through each of the first and second signal transmission lines 811 and 812.

The module controller circuit 850 may be coupled to the third and fourth signal transmission lines 813 and 814. The module controller circuit 850 may be coupled to a chip selection bus 802 through signal transmission lines formed in the module substrate 810 and may receive the first and second chip selection signals CS1 and CS2 from the external apparatus through the chip selection bus 802. The module controller circuit 850 may buffer the first and second chip selection signals CS1 and CS2 and may transmit the buffered first and second chip selection signals CS1 and CS2 to the memory chips M31 to M34 through the third and fourth signal transmission lines 813 and 814, respectively. The module controller circuit 850 may be coupled to a command address bus 803 via signal transmission lines formed in the module substrate 810 and may receive a command address signal CA from the external apparatus via the command address bus 803. The module controller circuit 850 may be coupled to a clock bus 804 via signal transmission lines formed in the module substrate 810 and may receive a clock signal CLK from the external apparatus or transmit the clock signal CLK to the external apparatus via the clock bus 804.

The first memory package 820 may include a first package substrate S31. The first package substrate S31 may be mounted on the front side of the module substrate 810. The first memory chip M31 may be disposed on the first package substrate S31, and the second memory chip M32 may be disposed on the first memory chip M31. The first memory chip M31 may be bonded to the first package substrate S31, and the second memory chip M32 may be bonded to the first memory chip M31 using DAF. The first package substrate S31 may include first pads 823. The first pads 823 may be coupled to the first signal transmission lines 811. The first pads 823 may be coupled to the first signal transmission lines 811 via package balls of the first package substrate S31. The data pads 821 of the first memory chip M31 and the data pads 822 of the second memory chip M32 may be coupled in common to the first pads 823. The data pads 821 of the first memory chip M31 may be connected to the first pads 823 via first bonding wires B31. The data pads 822 of the second memory chip M32 may be connected to the first pads 823 via second bonding wires B32. The first package substrate S31 may further include a second pad 824 and a third pad 825. The second pad 824 may be coupled to the third signal transmission line 813 and may receive the first chip selection signal CS1 transmitted from the module controller circuit 850 via the third signal transmission line 813. The third pad 825 may be coupled to the fourth signal transmission line 814 and may receive the second chip selection signal CS2 transmitted from the module controller circuit 850 via the fourth signal transmission line 814. The second and third pads 824 and 825 may be coupled to the third and fourth signal transmission lines 813 and 814 via package balls of the first package substrate S31, respectively. The first memory chip M31 may receive the first chip selection signal CS1 via the third signal transmission line 813 and the second pad 824. The first memory chip M31 may be connected to the second pad 824 via a third bonding wire B33. The second memory chip M32 may receive the second chip selection signal CS2 via the fourth signal transmission line 814 and the third pad 825. The second memory chip M32 may be connected to the third pad 825 via a fourth bonding wire B34.

The second memory package 830 may include a second package substrate S32. The second package substrate S32 may be mounted on a rear side of the module substrate 810. The third memory chip M33 may be disposed on the second package substrate S32, and the fourth memory chip M34 may be disposed on the third memory chip M33. The third memory chip M33 may be bonded to the second package substrate S32, and the fourth memory chip M34 may be bonded to the third memory chip M33 using DAF. The second package substrate S32 may include fourth pads 833. The fourth pads 833 may be coupled to the second signal transmission lines 812. The fourth pads 833 may be coupled to the second signal transmission lines 812 through package balls of the second package substrate S32. The data pads 831 of the third memory chip M33 and the data pads 832 of the fourth memory chip M34 may be coupled in common to the fourth pads 833. The data pads 831 of the third memory chip M33 may be connected to the fourth pads 833 through fifth bonding wires B35. The data pads 832 of the fourth memory chip M34 may be connected to the fourth pads 833 through sixth bonding wires B36. The second package substrate S32 may further include a fifth pad 834 and a sixth pad 835. The fifth pad 834 may be coupled to the third signal transmission line 813 and may receive the first chip selection signal CS1 transmitted from the module controller circuit 850 through the third signal transmission line 813. The sixth pad 835 may be coupled to the fourth signal transmission line 814 and may receive the second chip selection signal CS2 transmitted from the module controller circuit 850 through the fourth signal transmission line 814. The fifth and sixth pads 834 and 835 may be coupled to the third and fourth signal transmission lines 813 and 814, respectively, through package balls of the second package substrate S32. The third memory chip M33 may receive the first chip selection signal CS1 through the third signal transmission line 813 and the fifth pad 834. The third memory chip M33 may be connected to the fifth pad 834 through a seventh bonding wire B37. The fourth memory chip M34 may receive the second chip selection signal CS2 through the fourth signal transmission line 814 and the sixth pad 835. The fourth memory chip M34 may be connected to the sixth pad 835 through an eighth bonding wire B38.

The module controller circuit 850 may include a data control circuit 851 and a chip selection buffer 852. The data control circuit 851 may connect the data bus 801 in common with the first and second signal transmission lines 811 and 812. During a write operation, the data control circuit 851 may divide merged data signals received through the data bus 801 to generate first divided data signals and second divided data signals. The data control circuit 851 may transmit the first and second divided data signals to the first and second signal transmission lines 811 and 812, respectively. For example, the first divided data signals may be transmitted through the first signal transmission lines 811, and the second divided data signals may be transmitted through the second signal transmission lines 812. When the first chip selection signal CS1 is asserted, the first divided data signals may be transmitted to the first memory chip M31, and the second divided data signals may be transmitted to the third memory chip M33. When the second chip selection signal CS2 is asserted, the first divided data signals may be transmitted to the second memory chip M32, and the second divided data signals may be transmitted to the fourth memory chip M34. During a read operation, the data control circuit 851 may receive the first and second divided data signals through the first and second signal transmission lines 811 and 812, respectively. When the first chip selection signal CS1 is asserted, the first divided data signals may be output from the first memory chip M31, and the second divided data signals may be output from the third memory chip M33. When the second chip selection signal CS2 is asserted, the first divided data signals may be output from the second memory chip M32, and the second divided data signals may be output from the fourth memory chip M34. The data control circuit 851 may merge the first and second divided data signals to generate the merged data signals. The data control circuit 851 may output the merged data signals to the data bus 801 and transmit the merged data signals to the external apparatus through the data bus 801. The chip selection buffer 852 may receive the first and second chip selection signals CS1 and CS2 through the chip selection bus 802. The chip selection buffer 852 may buffer the first and second chip selection signals CS1 and CS2 and transmit the buffered first and second chip selection signals CS1 and CS2 to the first and second memory packages 820 and 830, respectively. The chip selection buffer 852 may output the first chip selection signal CS1 to the third signal transmission line 813 and output the second chip selection signal CS2 to the fourth signal transmission line 814.

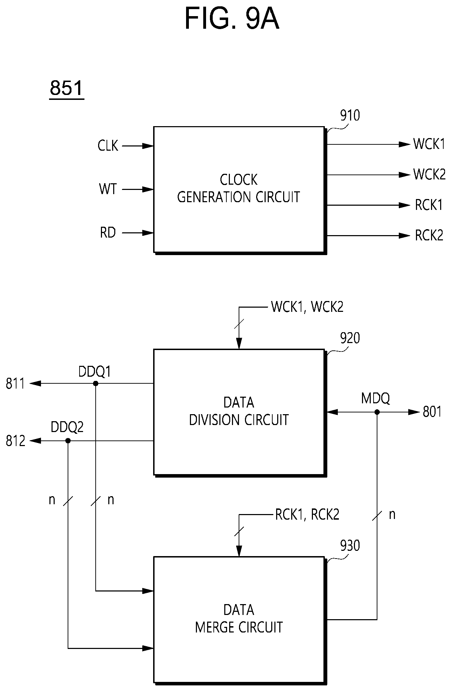

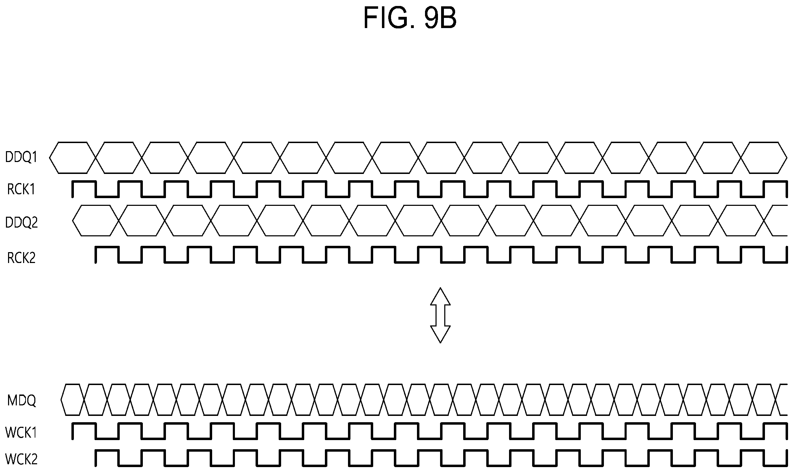

FIG. 9A is a diagram illustrating a configuration of the data control circuit 851 illustrated in FIG. 8, and FIG. 9B is a timing diagram illustrating an operation of the data control circuit 851. Referring to FIGS. 9A and 9B, the data control circuit 851 may include a clock generation circuit 910, a data division circuit 920, and a data merge circuit 930. The clock generation circuit 910 may receive the clock signal CLK, a write signal WT, and a read signal RD and may generate a first write clock signal WCK1, a second write clock signal WCK2, a first read clock signal RCK1, and a second read clock signal RCK2 based on the clock signal CLK, the write signal WT, and the read signal RD. When the memory module 800 performs the write operation, the write signal WT may be asserted, and the clock generation circuit 910 may generate the first and second write clock signals WCK1 and WCK2 from the clock signal CLK received from the external apparatus. The clock generation circuit 910 may generate the first write clock signal WCK1 having substantially the same phase as the clock signal CLK. The clock generation circuit 910 may generate the second write clock signal WCK2 having a phase difference of 180 degrees from the clock signal CLK and the first write clock signal WCK1 as shown in FIG. 9B. When the memory module 800 performs the read operation, the read signal RD may be asserted, and the clock generation circuit 910 may generate the first and second read clock signals RCK1 and RCK2 from the clock signal CLK transmitted from the first and second memory packages 820 and 830. The clock generation circuit 910 may generate the first read clock signal RCK1 having substantially the same phase as the clock signal CLK. The clock generation circuit 910 may generate the second read clock signal RCK2 having a phase difference of 180 degrees from the clock signal CLK and the first read clock signal RCK1 as shown in FIG. 9B.

The data division circuit 920 may be coupled to the data bus 801 and the first and second signal transmission lines 811 and 812 and may receive the first and second write clock signals WCK1 and WCK2. The data division circuit 920 may receive merged data signals MDQ through the data bus 801. The data division circuit 920 may generate first divided data signals DDQ1 and second divided data signals DDQ2 from the merged data signals MDQ based on the first and second write clock signals WCK1 and WCK2. The data division circuit 920 may generate the first divided data signals DDQ1 from odd-numbered data signals of the merged data signals MDQ in synchronization with rising edges of the first write clock signal WCK1. The data division circuit 920 may sample the merged data signals MDQ at each rising edge of the first write clock signal WCK1 as shown in FIG. 9B to generate the first divided data signals DDQ1. The data division circuit 920 may generate the second divided data signals DDQ2 from even-numbered data signals of the merged data signals MDQ in synchronization with rising edges of the second write clock signal WCK2. The data division circuit 920 may sample the merged data signals MDQ at each rising edge of the second write clock signal WCK2 as shown in FIG. 9B to generate the second divided data signals DDQ2. The data division circuit 920 may output the first divided data signals DDQ1 to the first signal transmission lines 811 and may output the second divided data signals DDQ2 to the second signal transmission lines 812.

The data merge circuit 930 may be coupled to the data bus 801 and the first and second signal transmission lines 811 and 812 and may receive the first and second read clock signals RCK1 and RCK2. The data merge circuit 930 may receive the first and second divided data signals DDQ1 and DDQ2 through the first and second signal transmission lines 811 and 812. The data merge circuit 930 may generate the merged data signals MDQ from the first and second divided data signals DDQ1 and DDQ2 based on the first and second read clock signals RCK1 and RCK2. The data merge circuit 930 may output the first divided data signals DDQ1 as the merged data signals MDQ in synchronization with rising edges of the first read clock signal RCK1. The data merge circuit 930 may output the second divided data signals DDQ2 as the merged data signals MDQ in synchronization with rising edges of the second read clock signal RCK2. Accordingly, odd-numbered bits of the merged data signals MDQ may have logic levels corresponding to the first divided data signals DDQ1, and even-numbered bits of the merged data signals MDQ may have logic levels corresponding to the second divided data signals DDQ2.

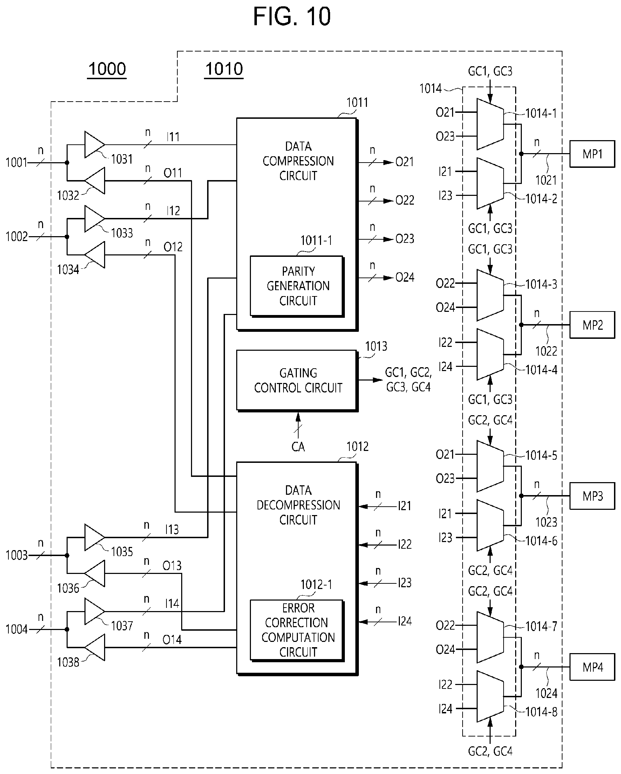

FIG. 10 is a diagram illustrating a configuration of a memory module 1000 according to an embodiment of the present disclosure. Referring to FIG. 10, the memory module 1000 may include a module controller circuit 1010 and a plurality of memory packages. The memory module 1000 may include first to fourth memory packages MP1 to MP4. For example, the first to fourth memory packages MP1 to MP4 may correspond to memory packages mounted on the front side of the module substrate 110 and forming the first sub-channel CH_A illustrated in FIG. 1. The module controller circuit 1010 may be coupled to the external apparatus through a plurality of data buses and may be coupled to each of the first to fourth memory packages MP1 to MP4 through a plurality of signal transmission lines. The module controller circuit 1010 may be coupled to the external apparatus through a first data bus 1001, a second data bus 1002, a third data bus 1003, and a fourth data bus 1004. Each of the first to fourth data buses 1001 to 1004 may include n signal transmission lines. The module controller circuit 1010 may be coupled to the first memory package MP1 through a first signal transmission line group 1021. The module controller circuit 1010 may be coupled to the second memory package MP2 through a second signal transmission line group 1022. The module controller circuit 1010 may be coupled to the third memory package MP3 through a third signal transmission line group 1023. The module controller circuit 1010 may be coupled to the fourth memory package MP4 through a fourth signal transmission line group 1024. The connection relationship between the module controller circuit 1010 and the first to fourth memory packages MP1 to MP4 may be implemented as any one of the connection relationships between the module controller circuit and memory packages illustrated in FIGS. 2A, 2B, 4A, and 4B. For example, as illustrated in FIG. 2A, the number of signal transmission lines included in each of the first to fourth signal transmission line groups 1021 to 1024 may be n. As illustrated in FIGS. 2B and 4A, the number of signal transmission lines included in each of the first to fourth signal transmission line groups 1021 to 1024 may be n*2. As illustrated in FIG. 4B, the number of signal transmission lines included in each of the first to fourth signal transmission line groups 1021 to 1024 may be n*4.

The module controller circuit 1010 may compress data signals received through the first to fourth data buses 1001 to 1004 and may transmit the compressed data signals to some of the first to fourth memory packages MP1 to MP4. The module controller circuit 1010 may decompress data signals transmitted from some of the first to fourth memory packages MP1 to MP4 and may output the decompressed data signals to the first to fourth data buses 1001 to 1004. For example, the module controller circuit 1010 may compress n*4 data signals received through the first to fourth data buses 1001 to 1004 to generate n*2 compressed data signals and may transmit the compressed data signals to the first and second memory packages MP1 and MP2 through the first and second signal transmission line groups 1021 and 1022, or to the third and fourth memory packages MP3 and MP4 through the third and fourth signal transmission line groups 1023 and 1024. The module controller circuit 1010 may decompress n*2 data signals transmitted from the first and second memory packages MP1 and MP2 through the first and second signal transmission line groups 1021 and 1022 or from the third and fourth memory packages MP3 and MP4 through the third and fourth signal transmission line groups 1023 and 1024 to generate n*4 decompressed data signals and may output the decompressed data signals through the first to fourth data buses 1001 to 1004. The module controller circuit 1010 may compress data signals received through the first to fourth data buses 1001 to 1004 and may transmit the compressed data signals to two memory packages instead of four memory packages. Therefore, the remaining two memory packages may store other compressed data signals. That is, the third and fourth memory packages MP3 and MP4 may be assigned address signals different from address signals assigned to the first and second memory packages MP1 and MP2, and the module controller circuit 1010 may logically increase a data storage capacity of the memory module 1000.

In an embodiment, the module controller circuit 1010 may further generate a parity signal based on data signals received through the first to fourth data buses 1001 to 1004. The module controller circuit 1010 may transmit the compressed data signals to some of the first to fourth memory packages MP1 to MP4 and transmit the parity signal to the remaining memory packages. For example, the module controller circuit 1010 may transmit the compressed data signals to the first and second memory packages MP1 and MP2 through the first and second signal transmission line groups 1021 and 1022, and may transmit the parity signal to the third and fourth memory packages MP3 and MP4 through the third and fourth signal transmission line groups 1023 and 1024. The module controller circuit 1010 may receive data signals from some of the first to fourth memory packages MP1 to MP4 and may receive a parity signal related to the data signals from the remaining memory packages of the first to fourth memory packages MP1 to MP4. For example, the module controller circuit 1010 may receive the data signals from the first and second memory packages MP1 and MP2 through the first and second signal transmission line groups 1021 and 1022, and may receive the parity signal from the third and fourth memory packages MP3 and MP4 through the third and fourth signal transmission line groups 1023 and 1024. The module controller circuit 1010 may decompress the data signals to generate decompressed data signals and may perform error correction on the decompressed data signals based on the decompressed data signals and the parity signal. The module controller circuit 1010 may output error-corrected data signals through the first to fourth data buses 1001 to 1004.

The module controller circuit 1010 may include a data compression circuit 1011, a data decompression circuit 1012, a gating control circuit 1013, and a gating circuit 1014. The data compression circuit 1011 may be coupled to the first to fourth data buses 1001 to 1004 and may receive data signals transmitted through the first to fourth data buses 1001 to 1004. The module controller circuit 1010 may include a plurality of receivers and a plurality of transmitters. The receiver 1031 may be coupled to the first data bus 1001, may buffer data signals transmitted through the first data bus 1001, and may provide the buffered data signals to the data compression circuit 1011. The receiver 1033 may be coupled to the second data bus 1002, may buffer data signals transmitted through the second data bus 1002, and may provide the buffered data signals to the data compression circuit 1011. The receiver 1035 may be coupled to the third data bus 1003, may buffer data signals transmitted through the third data bus 1003, and may provide the buffered data signals to the data compression circuit 1011. The receiver 1037 may be coupled to the fourth data bus 1004, may buffer data signals transmitted through the fourth data bus 1004, and may provide the buffered data signals to the data compression circuit 1011. First to fourth input lines I11, I12, I13, and I14 connecting the receivers 1031, 1033, 1035, and 1037 and the data compression circuit 1011 may each be n in number. The data compression circuit 1011 may compress data signals received through the input lines I11 to I14 and may generate compressed data signals. The compression ratio of the data compression circuit 1011 may be 50%, and all data signals received through the first to fourth data buses 1001 to 1004 may be compressed at the same compression ratio. The data compression circuit 1011 may output the compressed data signals through first and second output lines O21 and O22. The first and second output lines O21 and O22 may each be n in number.

The data decompression circuit 1012 may receive data signals transmitted from the first to fourth memory packages MP1 to MP4 through first and second input lines I21 and I22. The data decompression circuit 1012 may decompress data signals received through the first and second input lines I21 and I22 to generate decompressed data signals. The first and second input lines I21 and I22 may each be n in number. The data decompression circuit 1012 may output the decompressed data signals through first to fourth output lines O11, 012, 013, and 014. The transmitter 1032 may buffer data signals output through the first output lines O11 and may output the buffered data signals to the first data bus 1001. The transmitter 1034 may buffer data signals output through the second output lines 012 and may output the buffered data signals to the second data bus 1002. The transmitter 1036 may buffer data signals output through the third output lines 013 and may output the buffered data signals to the third data bus 1003. The transmitter 1038 may buffer data signals output through the fourth output lines 014 and may output the buffered data signals to the fourth data bus 1004. The first to fourth output lines O11 to O14 may each be n in number.

The gating control circuit 1013 may receive a command address signal CA. The gating control circuit 1013 may generate at least a first gating control signal GC1 and a second gating control signal GC2 based on the command address signal CA. The gating control circuit 1013 may selectively enable the first and second gating control signals GC1 and GC2 according to a logic level of at least one bit of the command address signal CA. For example, when a logic level of a specific bit of the command address signal CA is a first logic level, the gating control circuit 1013 may enable the first gating control signal GC1 and may disable the second gating control signal GC2. When a logic level of the specific bit of the command address signal CA is a second logic level, the gating control circuit 1013 may enable the second gating control signal GC2 and may disable the first gating control signal GC1.

The gating circuit 1014, which comprises multiplexing and demultiplexing circuits, may receive the first and second gating control signals GC1 and GC2 and may gate the first and second output lines O21 and O22 and the first to fourth signal transmission line groups 1021 to 1024 based on the first and second gating control signals GC1 and GC2. The gating circuit 1014 may gate the first and second input lines I21 and I22 from the first to fourth signal transmission line groups 1021 to 1024 based on the first and second gating control signals GC1 and GC2. The gating circuit 1014 may connect the first output lines O21 and the first input lines I21 to one of the first and third signal transmission line groups 1021 and 1023 based on the first and second gating control signals GC1 and GC2. The gating circuit 1014 may connect the first output lines O21 and the first input lines I21 to the first signal transmission line group 1021 when the first gating control signal GC1 is enabled, and may connect the first output lines O21 and the first input lines I21 to the third signal transmission line group 1023 when the second gating control signal GC2 is enabled. The gating circuit 1014 may connect the second output lines O22 and the second input lines I22 to one of the second and fourth signal transmission line groups 1022 and 1024 based on the first and second gating control signals GC1 and GC2. The gating circuit 1014 may connect the second output lines O22 and the second input lines I22 to the second signal transmission line group 1022 when the first gating control signal GC1 is enabled, and may connect the second output lines O22 and the second input lines I22 to the fourth signal transmission line group 1024 when the second gating control signal GC2 is enabled.

In an embodiment, the data compression circuit 1011 may further include a parity generation circuit 1011-1. The parity generation circuit 1011-1 may generate the parity signal based on the data signals received from the first to fourth input lines 111, 112, 113, and I14. The data compression circuit 1011 may be further coupled to third and fourth output lines O23 and O24. The third and fourth output lines may each be n in number. The data compression circuit 1011 may output the parity signal through the third and fourth output lines O23 and O24. The data decompression circuit 1012 may further include an error correction computation circuit 1012-1. The data decompression circuit 1012 may be further coupled to third and the fourth input lines I23 and I24. The third input lines I23 and the fourth input lines I24 may each include n lines. The data decompression circuit 1012 may receive the parity signal through the third input lines I23 and the fourth input lines I24. The error correction computation circuit 1012-1 may perform error correction for the decompressed data signals based on the decompressed data signals and the parity signal to generate the error-corrected data signals.

The gating control circuit 1013 may further generate a third gating control signal GC3 and a fourth gating control signal GC4 based on the command address signal CA. The gating control circuit 1013 may generate the third gating control signal GC3 and the fourth gating control signal GC4 according to a logic level of the at least one bit of the command address signal CA. The gating control circuit 1013 may complementarily generate the third gating control signal GC3 and the fourth gating control signal GC4 with the first gating control signal GC1 and the second gating control signal GC2 according to a logic level of the specific bit. For example, when the specific bit has a first logic level, the gating control circuit 1013 may enable the first gating control signal GC1 and the fourth gating control signal GC4 and disable the second gating control signal GC2 and the third gating control signal GC3. The gating control circuit 1013 may enable the second gating control signal GC2 and the third gating control signal GC3 and disable the first gating control signal GC1 and the fourth gating control signal GC4 when the specific bit has a second logic level.

The gating circuit 1014 may further receive the third gating control signal GC3 and the fourth gating control signal GC4 and may gate the first to fourth output lines O21 to O24 with the first to fourth signal transmission line groups 1021 to 1024 based on the first to fourth gating control signals GC1 to GC4 and may gate the first to fourth signal transmission line groups 1021 to 1024 to the first to fourth input lines I21 to I24. When the first gating control signal GC1 and the fourth gating control signal GC4 are enabled and the second gating control signal GC2 and the third gating control signal GC3 are disabled, the gating circuit 1014 may connect the first output lines O21 and the first input lines I21 with the first signal transmission line group 1021 and may connect the second output lines O22 and the second input lines I22 with the second signal transmission line group 1022. The gating circuit 1014 may connect the third output lines O23 and the third input lines I23 with the third signal transmission line group 1023 and may connect the fourth output lines O24 and the fourth input lines I24 with the fourth signal transmission line group 1024. When the second gating control signal GC2 and the third gating control signal GC3 are enabled and the first gating control signal GC1 and the fourth gating control signal GC4 are disabled, the gating circuit 1014 may connect the third output lines O23 and the third input lines I23 with the first signal transmission line group 1021 and may connect the fourth output lines O24 and the fourth input lines I24 with the second signal transmission line group 1022. The gating circuit 1014 may connect the first output lines O21 and the first input lines I21 with the third signal transmission line group 1023 and may connect the second output lines O22 and the second input lines I22 with the fourth signal transmission line group 1024.

The gating circuit 1014 may include a plurality of multiplexers and a plurality of demultiplexers. The multiplexer 1014-1 may receive the first gating control signal GC1 and may transmit compressed data signals output through the first output lines O21 to the first memory package MP1 through the first signal transmission line group 1021 when the first gating control signal GC1 is enabled. The multiplexer 1014-3 may receive the first gating control signal GC1 and may transmit compressed data signals output through the second output lines O22 to the second memory package MP2 through the second signal transmission line group 1022 when the first gating control signal GC1 is enabled. The multiplexer 1014-5 may receive the second gating control signal GC2 and may transmit compressed data signals output through the first output lines O21 to the third memory package MP3 through the third signal transmission line group 1023 when the second gating control signal GC2 is enabled. The multiplexer 1014-7 may receive the second gating control signal GC2 and may transmit compressed data signals output through the second output lines O22 to the fourth memory package MP4 through the fourth signal transmission line group 1024 when the second gating control signal GC2 is enabled. In an embodiment, the multiplexers 1014-1 and 1014-3 may further receive the third gating control signal GC3, and the multiplexers 1014-5 and 1014-7 may further receive the fourth gating control signal GC4. The multiplexer 1014-1 may transmit the parity signal output through the third output lines O23 to the first memory package MP1 through the first signal transmission line group 1021 when the third gating control signal GC3 is enabled. The multiplexer 1014-3 may transmit the parity signal output through the fourth output lines O24 to the second memory package MP2 through the second signal transmission line group 1022 when the third gating control signal GC3 is enabled. The multiplexer 1014-5 may transmit the parity signal output through the third output lines O23 to the third memory package MP3 through the third signal transmission line group 1023 when the fourth gating control signal GC4 is enabled. The multiplexer 1014-7 may transmit the parity signal output through the fourth output lines O24 to the fourth memory package MP4 through the fourth signal transmission line group 1024 when the fourth gating control signal GC4 is enabled.

The demultiplexer 1014-2 may receive the first gating control signal GC1 and may output data signals transmitted through the first signal transmission line group 1021 to the first input lines I21 when the first gating control signal GC1 is enabled. The demultiplexer 1014-4 may receive the first gating control signal GC1 and may output data signals transmitted through the second signal transmission line group 1022 to the second input lines I22 when the first gating control signal GC1 is enabled. The demultiplexer 1014-6 may receive the second gating control signal GC2 and may output data signals transmitted through the third signal transmission line group 1023 to the first input lines I21 when the second gating control signal GC2 is enabled. The demultiplexer 1014-8 may receive the second gating control signal GC2 and may output data signals transmitted through the fourth signal transmission line group 1024 to the second input lines I22 when the second gating control signal GC2 is enabled. In an embodiment, the demultiplexers 1014-2 and 1014-4 may further receive the third gating control signal GC3, and the demultiplexers 1014-6 and 1014-8 may further receive the fourth gating control signal GC4. The demultiplexer 1014-2 may output the parity signal transmitted through the first signal transmission line group 1021 to the third input lines I23 when the third gating control signal GC3 is enabled. The demultiplexer 1014-4 may output the parity signal transmitted through the second signal transmission line group 1022 to the fourth input lines I24 when the third gating control signal GC3 is enabled. The demultiplexer 1014-6 may output the parity signal transmitted through the third signal transmission line group 1023 to the third input lines I23 when the fourth gating control signal GC4 is enabled. The demultiplexer 1014-8 may output the parity signal transmitted through the fourth signal transmission line group 1024 to the fourth input lines I24 when the fourth gating control signal GC4 is enabled.

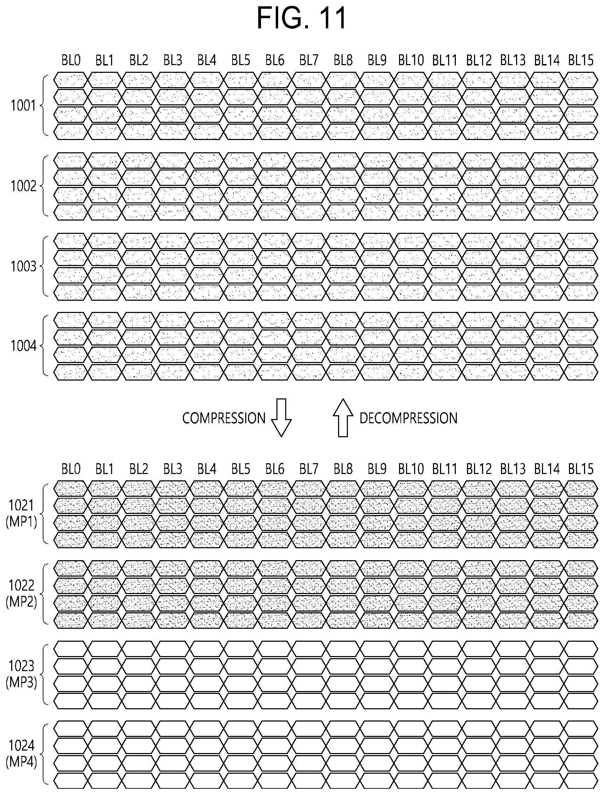

FIG. 11 is a timing diagram illustrating an operation of the memory module 1000 according to an embodiment of the present disclosure. Referring to FIG. 10 and FIG. 11, during the write operation, data signals may be received from the external apparatus through the first to fourth data buses 1001 to 1004. A burst length of the data signals may be 16. Accordingly, a total of 256-bit data signals may be received through the first to fourth data buses 1001 to 1004. The data compression circuit 1011 may compress the data signals to generate compressed data signals. For example, when a compression ratio of the data compression circuit 1011 is 50%, the data compression circuit 1011 may generate a total of 128-bit compressed data signals. The module controller circuit 1010 may transmit the compressed data signals to two memory packages among the first to fourth memory packages MP1 to MP4 through two of the first to fourth signal transmission line groups 1021 to 1024. For example, based on a first command address signal, when the first gating control signal GC1 is enabled, the compressed data signals may be transmitted to the first and second memory packages MP1 and MP2 through the first and second signal transmission line groups 1021 and 1022 and may be stored in the first and second memory packages MP1 and MP2. The data signals might not be transmitted to the third and fourth memory packages MP3 and MP4 through the third and fourth signal transmission line groups 1023 and 1024. When the second command address signal is received instead of the first command address signal, the second gating control signal GC2 may be enabled, and the compressed data signals may be transmitted to the third and fourth memory packages MP3 and MP4 through the third and fourth signal transmission line groups 1023 and 1024 and may be stored in the third and fourth memory packages MP3 and MP4. The data signals might not be transmitted to the first and second memory packages MP1 and MP2 through the first and second signal transmission line groups 1021 and 1022. During the read operation, the data decompression circuit 1012 may receive data signals from the first and second memory packages MP1 and MP2 through the first and second signal transmission line groups 1021 and 1022. The data decompression circuit 1012 may decompress the data signals to generate decompressed data signals. The data signals output from the first and second memory packages MP1 and MP2 may be 128 bits in total, and the decompressed data signals may be 256 bits in total. The module controller circuit 1010 may transmit the decompressed data signals to the external apparatus through the first to fourth data buses 1001 to 1004. The module controller circuit 1010 including the data compression circuit 1011 and the data decompression circuit 1012 may assign address signals different from those of the first and second memory packages MP1 and MP2 to the third and fourth memory packages MP3 and MP4, thereby increasing a logical data storage capacity of the memory module at least twofold.

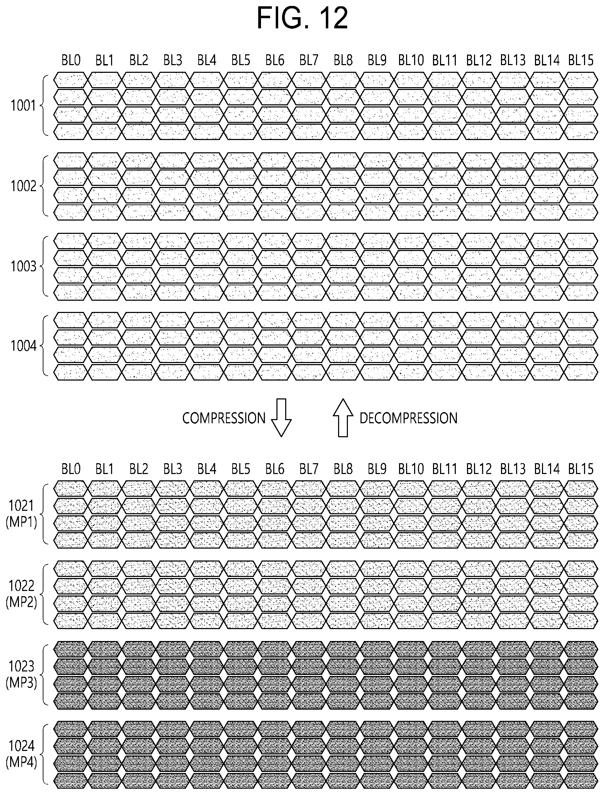

FIG. 12 is a diagram illustrating an operation of the memory module 1000 according to an embodiment of the present disclosure. Referring to FIG. 10 and FIG. 12, during the write operation, a total of 256-bit data signals may be received from the external apparatus through the first to fourth data buses 1001 to 1004. The data compression circuit 1011 may compress the data signals to generate a total of 128-bit compressed data signals. The parity generation circuit 1011-1 may generate a plurality of parity signals based on the data signals. The parity generation circuit may generate up to 128-bit parity signals. The module controller circuit 1010 may transmit the compressed data signals to two memory packages among the first to fourth memory packages MP1 to MP4 through two of the first to fourth signal transmission line groups 1021 to 1024. For example, based on the first command address signal, when the first and fourth gating control signals GC1 and GC4 are enabled, the compressed data signals may be transmitted to the first and second memory packages MP1 and MP2 through the first and second signal transmission line groups 1021 and 1022, and the parity signals may be transmitted to the third and fourth memory packages MP3 and MP4 through the third and fourth signal transmission line groups 1023 and 1024. When the second command address signal is received instead of the first command address signal, the second and third gating control signals GC2 and GC3 may be enabled, and the compressed data signals may be transmitted to the third and fourth memory packages MP3 and MP4 through the third and fourth signal transmission line groups 1023 and 1024, and the parity signals may be transmitted to the first and second memory packages MP1 and MP2 through the first and second signal transmission line groups 1021 and 1022. During the read operation, the data decompression circuit 1012 may receive data signals from the first and second memory packages MP1 and MP2 through the first and second signal transmission line groups 1021 and 1022, and may receive the parity signals from the third and fourth memory packages MP3 and MP4 through the third and fourth signal transmission line groups 1023 and 1024. The data decompression circuit 1012 may decompress the data signals to generate decompressed data signals. The data signals output from the first and second memory packages MP1 and MP2 may be 128 bits in total, and the decompressed data signals may be 256 bits in total. The error correction computation circuit 1012-1 may perform error correction for the decompressed data signals based on the parity signals. As the number of the parity signals increases, the number of bits that can be error-corrected may increase. For example, when the number of the parity signals is maximized, error correction may be possible for more than 20% of arbitrary bits of the decompressed data signals. Therefore, the module controller circuit 1010 can increase reliability of the memory module 1000. The module controller circuit 1010 may transmit the error-corrected data signals to the external apparatus through the first to fourth data buses 1001 to 1004.

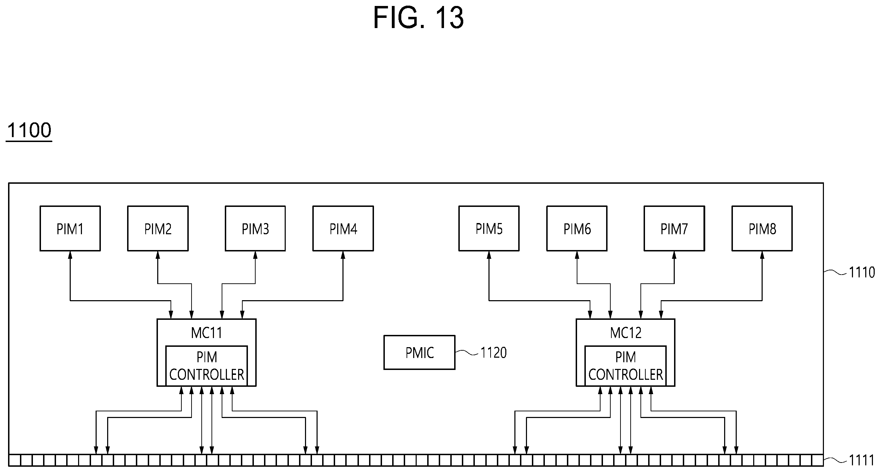

FIG. 13 is a diagram illustrating a configuration of a memory module 1100 according to an embodiment of the present disclosure. Referring to FIG. 13, the memory module 1100 may include a module substrate 1110, a first module controller circuit MC11, a second module controller circuit MC12, a first processing in memory package PIM1, a second processing in memory package PIM2, a third processing in memory package PIM3, a fourth processing in memory package PIM4, a fifth processing in memory package PIM5, a sixth processing in memory package PIM6, a seventh processing in memory package PIM7, and an eighth processing in memory package PIM8. The first and second module controller circuits MC11 and MC12, and the first to eighth processing in memory packages PIM1 to PIM8 may be mounted on the module substrate 1110. The first module controller circuit MC11 and the first to fourth memory packages PIM1 to PIM4 may constitute a first sub-channel of the memory module 1100. The second module controller circuit MC12 and the fifth to eighth processing in memory packages PIM5 to PIM8 may constitute a second sub-channel of the memory module 1100. The first module controller circuit MC11 may be coupled to an external apparatus of the memory module 1100 through a signal transmission line formed in the module substrate 1110 and module pins 1111. The first module controller circuit MC11 may be coupled to the first to fourth processing in memory packages PIM1 to PIM4 through signal transmission lines formed in the module substrate 1110. The second module controller circuit MC12 may be coupled to the external apparatus through a signal transmission line formed in the module substrate and the module pins 1111. The second module controller circuit MC12 may be coupled to the fifth to eighth processing in memory packages PIM5 to PIM8 through signal transmission lines formed in the module substrate 1110.

The first and second module controller circuits MC11 and MC12 may each include a PIM (Processing In Memory) controller. The first to eighth processing in memory packages PIM1 to PIM8 may each include a PIM apparatus having processing units. The PIM controller may generate command address signals to support operations of the plurality of PIMs. The first and second module controller circuits MC11 and MC12 may support operations of the plurality of PIMs without modifying an interface between the external apparatus and the module controller circuits MC11 and MC12 because they include a PIM controller. Therefore, the memory module 1100 may be coupled to the external apparatus through a conventional interface and may function as an accelerator to increase a processing speed of the external apparatus. The memory module 1100 may perform a part or all of processing operations performed by the external apparatus. The memory module 1100 may perform processing operations together with the external apparatus or independently. A power management integrated circuit 1120, (PMIC) is disposed on the module substrate 1110. The first and second module controller circuits MC11 and MC22 and the first to eighth memory packages PIM1 to PIM8 may operate based on first and second power voltages VDD and VDDQ.

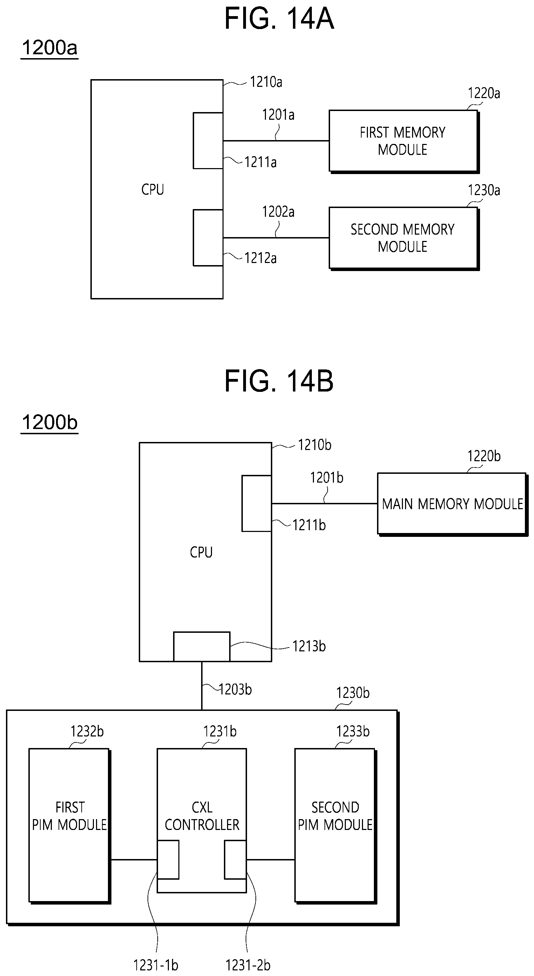

FIG. 14A is a diagram illustrating a configuration of a computing system 1200a according to an embodiment of the present disclosure. Referring to FIG. 14A, the computing system 1200a may include a central processing unit (CPU) 1210a, a first memory module 1220a, and a second memory module 1230a. The central processing unit 1210a may control the first and second memory modules 1220a and 1230a to perform data communication with the first and second memory modules 1220a and 1230a. The central processing unit 1210a may be coupled to the first memory module 1220a through a first memory channel 1201a and may be coupled to the second memory module 1230a through a second memory channel 1202a. The first and second memory channels (1201a and 1202a) may have substantially the same characteristics. The second memory module 1230a may be a memory module of a different type from the first memory module 1220a. The first memory module 1220a may function as a main memory of the central processing unit 1210a. The second memory module 1230a may function as an accelerator of the central processing unit 1210a. For example, the first memory module 1220a may be implemented as a general memory module or as any one of the memory modules 100, 200a, 200b, 400a, 400b, 800, and 1000 illustrated in FIG. 1, FIG. 2A, FIG. 2B, FIG. 4A, FIG. 4B, FIG. 8, and FIG. 10. The second memory module 1230a may be implemented as the memory module 1100 illustrated in FIG. 13. Because the second memory module 1230a may be coupled to the central processing unit 1210a through a memory channel having the same characteristics as the first memory module 1220a, it may be possible to improve processing performance of the central processing unit 1210a without modifying a design of the central processing unit 1210a and the memory channels.

FIG. 14B is a diagram illustrating a configuration of a computing system 1200b according to an embodiment of the present disclosure. Referring to FIG. 14B, the computing system 1200b may include a central processing unit 1210b, a main memory module 1220b, and a CXL (Compute Express Link) device 1230b. The central processing unit 1210b may control the main memory module 1220b and the CXL device 1230b to perform data communication with the main memory module 1220b and the CXL device 1230b. The central processing unit 1210b may be coupled to the first memory module 1220b through a memory channel 1201b and may be coupled to the CXL device 1230b through a serial interface 1203b. The serial interface 1203b may include PCIe (Peripheral Component Interconnect Express) or CXL. The CXL device 1230b may include a CXL controller 1231b, a first PIM module 1232b, and a second PIM module 1233b. The first and second PIM modules 1232b and 1233b may be mounted in slots provided in the CXL device 1230b and may be coupled to the CXL controller 1231b. The CXL controller 1231b may be coupled to the central processing unit 1210b through the serial interface 1203b and may receive requests and data transmitted from the central processing unit 1210b. The CXL controller 1231b may further include PIM controllers 1231-1b and 1231-2b. The PIM controller 1231-1b may relay communication between the first PIM module 1232b and the CXL controller 1231b, and the PIM controller 1231-2b may relay communication between the second PIM module 1233b and the CXL controller 1231b. The first and second PIM modules 1232b and 1233b may each be implemented as the memory module 1100 illustrated in FIG. 13.

Concepts are disclosed in conjunction with examples and embodiments. Those skilled in the art will understand that various modifications, additions, combinations, and substitutions are possible without departing from the scope and technical concepts of the present disclosure. The embodiments disclosed in the present specification should be considered from an illustrative standpoint and not a restrictive standpoint. Therefore, the scope of the present disclosure is not limited to the provided descriptions. All changes within the meaning and range of equivalency of the claims are included within their scope.

## Claims

1. A memory module, comprising:
a module substrate including first signal transmission lines and second signal transmission lines;
a first memory package mounted on a front side of the module substrate, the first memory package including a first memory chip accessed by a first chip selection signal and a second memory chip accessed by a second chip selection signal, wherein data pads of the first memory chip and data pads of the second memory chip are coupled in common to the first signal transmission lines;
a second memory package mounted on a rear side of the module substrate, the second memory package including a third memory chip accessed by a third chip selection signal and a fourth memory chip accessed by a fourth chip selection signal, wherein data pads of the third memory chip and data pads of the fourth memory chip are coupled in common to the second signal transmission lines; and
a module controller circuit mounted on the front side of the module substrate, the module controller circuit being coupled to an external apparatus through a data bus and configured to connect the data bus to one of the first signal transmission lines and the second signal transmission lines based on the first to fourth chip selection signals.

2. The memory module of claim 1, wherein the module substrate further includes a third signal transmission line, a fourth signal transmission line, a fifth signal transmission line, and a sixth signal transmission line,
the module controller circuit is configured to receive the first to fourth chip selection signals from the external apparatus and transmit the first to fourth chip selection signals to the third to sixth signal transmission lines, respectively, and
the first memory chip is configured to receive the first chip selection signal through the third signal transmission line, the second memory chip is configured to receive the second chip selection signal through the fourth signal transmission line, the third memory chip is configured to receive the third chip selection signal through the fifth signal transmission line, and the fourth memory chip is configured to receive the fourth chip selection signal through the sixth signal transmission line.

3. The memory module of claim 1, wherein the first memory package further includes a first package substrate having first pads coupled to the first signal transmission lines, the first memory chip is disposed on the first package substrate, the second memory chip is disposed on the first memory chip, and the data pads of the first memory chip and the data pads of the second memory chip are coupled in common to the first pads.

4. The memory module of claim 3, wherein the data pads of the first memory chip are connected to the first pads through first bonding wires, and the data pads of the second memory chip are connected to the first pads through second bonding wires.

5. The memory module of claim 4, wherein the first package substrate further includes a second pad to receive the first chip selection signal and a third pad to receive the second chip selection signal, the first memory chip is connected to the second pad through a third bonding wire, and the second memory chip is connected to the third pad through a fourth bonding wire.

6. The memory module of claim 1, wherein the second memory package further includes a second package substrate having fourth pads coupled to the second signal transmission lines, the third memory chip is disposed on the second package substrate, the fourth memory chip is disposed on the third memory chip, and the data pads of the third memory chip and the data pads of the fourth memory chip are coupled in common to the fourth pads.

7. The memory module of claim 6, wherein the data pads of the third memory chip are connected to the fourth pads through fifth bonding wires, and the data pads of the fourth memory chip are connected to the fourth pads through sixth bonding wires.

8. The memory module of claim 7, wherein the second package substrate further includes a fifth pad to receive the third chip selection signal and a sixth pad to receive the fourth chip selection signal, the third memory chip is connected to the fifth pad through a seventh bonding wire, and the fourth memory chip is connected to the sixth pad through an eighth bonding wire.

9. The memory module of claim 1, wherein a number of the first signal transmission lines and a number of the second signal transmission lines each is substantially the same as a number of signal transmission lines included in the data bus.

10. The memory module of claim 1, wherein the module controller circuit is configured to connect the data bus to the first signal transmission lines when the first chip selection signal or the second chip selection signal is asserted, and configured to connect the data bus to the second signal transmission lines when the third chip selection signal or the fourth chip selection signal is asserted.

11. The memory module of claim 1, wherein the module controller circuit comprises:
a data control circuit configured to connect the data bus to one of the first and second signal transmission lines based on the first to fourth chip selection signals; and
a chip selection buffer configured to buffer the first to fourth chip selection signals and configured to transmit the buffered first to fourth chip selection signals to the first to fourth memory chips, respectively.

12. The memory module of claim 11, wherein the data control circuit comprises:
a selection control circuit configured to generate a first input selection signal, a second input selection signal, a first output selection signal, and a second output selection signal based on the first to fourth chip selection signals, a write signal, and a read signal;
an input data selection circuit configured to connect the first signal transmission lines to the data bus when the first input selection signal is enabled and configured to connect the second signal transmission lines to the data bus when the second input selection signal is enabled; and
an output data selection circuit configured to connect the first signal transmission lines to the data bus when the first output selection signal is enabled and configured to connect the second signal transmission lines to the data bus when the second output selection signal is enabled.

13. A memory module, comprising:
a module substrate including first signal transmission lines and second signal transmission lines;
a memory package mounted on the module substrate, the memory package including a first memory chip accessed by a first chip selection signal, a second memory chip accessed by a second chip selection signal, a third memory chip accessed by a third chip selection signal, and a fourth memory chip accessed by a fourth chip selection signal, wherein data pads of the first memory chip and data pads of the second memory chip are coupled in common to the first signal transmission lines, and data pads of the third memory chip and data pads of the fourth memory chip are coupled in common to the second signal transmission lines; and
a module controller circuit mounted on the module substrate, the module controller circuit being coupled to an external apparatus through a data bus and configured to connect the data bus to one of the first and second signal transmission lines based on the first to fourth chip selection signals.

14. The memory module of claim 13, wherein the module substrate further includes a third signal transmission line, a fourth signal transmission line, a fifth signal transmission line, and a sixth signal transmission line,
the module controller circuit is configured to receive the first to fourth chip selection signals from the external apparatus, configured to buffer the first to fourth chip selection signals, and configured to transmit the buffered first to fourth chip selection signals to the third to sixth signal transmission lines, respectively, and
the first memory chip is configured to receive the first chip selection signal through the third signal transmission line, the second memory chip is configured to receive the second chip selection signal through the fourth signal transmission line, the third memory chip is configured to receive the third chip selection signal through the fifth signal transmission line, and the fourth memory chip is configured to receive the fourth chip selection signal through the sixth signal transmission line.

15. The memory module of claim 13, wherein the memory package further includes a package substrate having first pads coupled to the first signal transmission lines and second pads coupled to the second signal transmission lines,
the first memory chip is disposed on the package substrate, the second memory chip is disposed on the first memory chip, the third memory chip is disposed on the second memory chip, and the fourth memory chip is disposed on the third memory chip, and
the data pads of the first memory chip and the data pads of the second memory chip are coupled in common to the first pads, and the data pads of the third memory chip and the data pads of the fourth memory chip are coupled in common to the second pads.
